Europäisches Patentamt

European Patent Office

Office européen des brevets

(11) Publication number: **0 413 311 A2**

# EUROPEAN PATENT APPLICATION

(21) Application number: 90115589.5

(51) Int. Cl.5: **H03G 3/20**

(22) Date of filing: 14.08.90

(30) Priority: 16.08.89 JP 210084/89
23.03.90 JP 72055/90

(43) Date of publication of application:
20.02.91 Bulletin 91/08

(84) Designated Contracting States:
DE GB

(71) Applicant: HITACHI, LTD.
6, Kanda Surugadai 4-chome
Chiyoda-ku, Tokyo 100(JP)

Applicant: KOKUSAI ELECTRIC CO., LTD.
3-13, 2-Chome, Toranomon, Minato-ku
Tokyo-to(JP)

(72) Inventor: Nakagoshi, Arata, Hitachi
Keimei-Ryo
14-13, Honda-3-chome
Kokubunji-shi(JP)
Inventor: Tsukamoto, Nobuo
51-6, Ichibancho-1-chome
Tachikawa-shi(JP)
Inventor: Noguchi, Hiroshi
8-13-403, Shinmeidai-2-chome, Hamuramachi
Nishitama-gun, Tokyo(JP)
Inventor: Nakagawa, Junichi
29-16, Nakaarai-4-chome
Tokorozawa-shi(JP)
Inventor: Mitomo, Isamu
1429-329, Hatsuzawamachi
Hachioji-shi(JP)
Inventor: Hoshi, Atushi
2-1-KF 103, Shinmeidai-2-chome
Hamuramachi
Nishitama-gun Tokyo(JP)
Inventor: Horaguchi, Masato
9-25, Bunkamachi Wakabayashi-ku,
Sendai-shi(JP)

(74) Representative: Strehl, Schübel-Hopf,
Groening
Maximilianstrasse 54 Postfach 22 14 55
D-8000 München 22(DE)

(54) A radio receiver and a radio receiver using a direct conversion.

(57) The present invention relates to a radio receiver for outputting a signal which has been demodulated from a radio frequency band signal received by an antenna, and in particular to a radio receiver which converts a radio frequency band signal into an intermediate frequency and then converts it into a digital signal for demodulating the same or a radio receiver using a direct conversion. The present invention is characterized in that an amplifier (2) for amplifying the radio frequency band signal received by the antenna comprises a variable gain amplifier and the radio receiver further includes a gain controller (3) for controlling the gain of the radio frequency variable gain amplifier.

## FIG. 1

# A RADIO RECEIVER AND A RADIO RECEIVER USING A DIRECT CONVERSION

## BACKGROUND OF THE INVENTION

### Field of the Invention

The present invention relates to a radio receiver which converts a radio frequency band signal into a low frequency band signal and then converts it into a digital signal for demodulating the same or a radio receiver using a direct conversion.

### Description of the Related Art

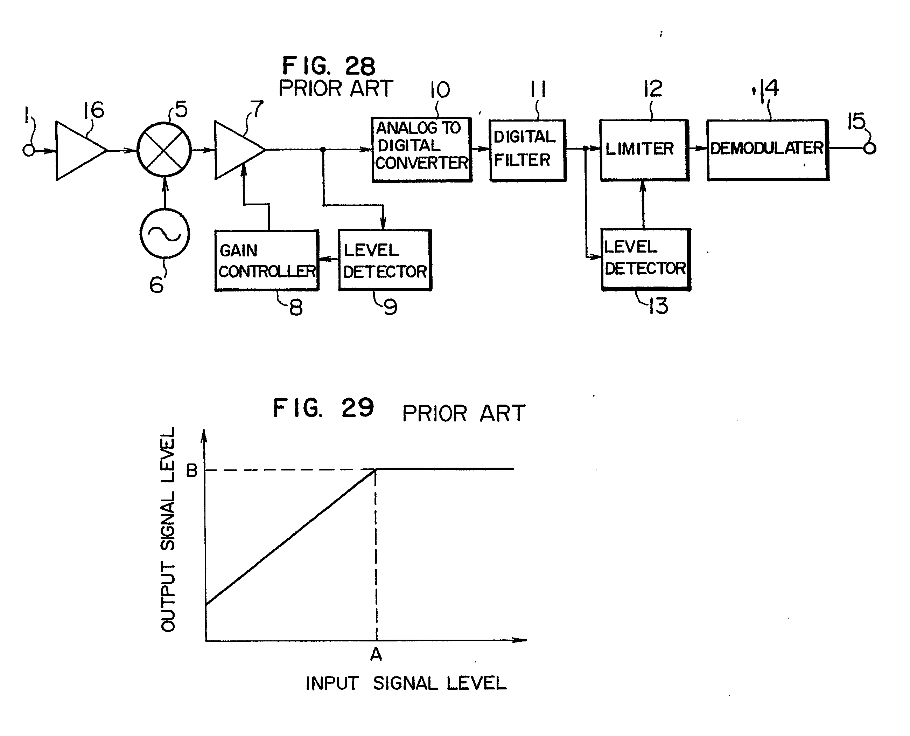

An example of a first prior art receiver is shown in Fig. 28. The first prior art receiver converts the frequency of the received frequency-modulated signal into an intermediate frequency (IF) and thereafter converts the IF signal into a digital signal by means of an A/D converter for conducting frequency band limitation, amplitude limitation and demodulation of the frequency-modulated signal by digital signal processing techniques. In Fig. 28, a received signal having a radio frequency falling in an RF band including a plurality of channels is inputted into an RF amplifier 16 via an antenna. The received signal which is amplified by an RF amplifier 16 is then inputted into a mixer 5. In a usual receiver, a band pass filter is interposed between the RF amplifier 16 and the mixer 5 for preliminarily selecting frequency modulated signals of all channels which are desired to be received. In the mixer 5, the frequency of the received signal is converted into an IF band depending on the frequency of a local oscillation signal from a local oscillator 6 and the frequency of the received signal. The received signal, the frequency of which has been converted into an IF band, is amplified in an IF band variable gain amplifier 7 and is then converted into a digital signal by an A/D converter 10. Since an over-input level of the inputted signal causes the A/D converter 10 to be saturated to generate distortion in the received signal, the gain of the IF band variable gain amplifier 7 is changed via a gain controller 8 depending upon the output level of the IF band variable gain amplifier 7 which is detected by a level detector 9. In such a manner, the input level of the A/D converter 10 is controlled so that it will not exceed a preset value. Although signal level may be expressed by effective value or wave height value and what is expressed by the output value is different depending upon the configuration of the circuit of the level detector, the level is expressed by effective value herein for convenience of description. Following digital signal level will be similarly expressed.

The received signal which has been converted into a digital signal by the A/D converter 10 is then inputted into a digital filter 11 at which only a signal which is desired to be modulated (hereinafter referred to as desired signal) is selected from a plurality of channels. The desired signal is subject to amplitude limitation suitable for the characteristics of the demodulator before the desired signal which is an output of the digital filter 11 is applied to the modulator 14. The output of the digital filter 11 is inputted to a digital level detector 13 for limiting the amplitude of the desired signal by a limiter 12 by using the result of the level detection of the digital level detector 13. The desired signal, the amplitude of which has been limited, is inputted to the modulator 14 for demodulation.

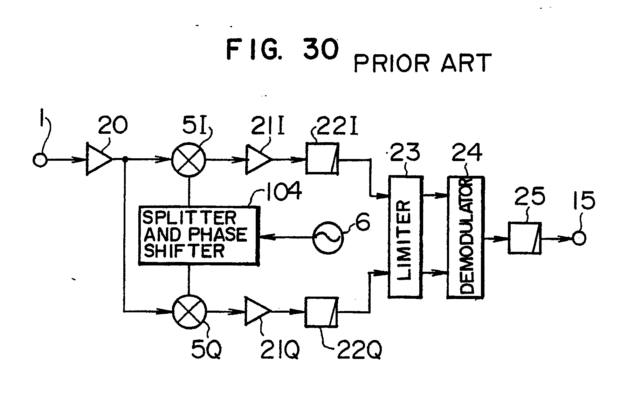

A second prior art radio receiver is described in IEEE, Proc. Vol. 129, Pt, F, No. 1 (1982. 2) pp. 2 through 6. A basic structure of a direct conversion receiver is shown in Fig. 30. A received signal including a plurality of channels is inputted from an antenna via an input terminal 1 to an RF amplifier 20. The received signal which is amplified by the RF amplifier 20 is divided into two signals and the divided signals are inputted to two mixers 5I and 5Q, respectively. A local oscillator 6 generates a local oscillation signal having an oscillation frequency substantially equal to a carrier frequency of a signal of a channel which is desired to be received (hereinafter referred to as desired signal). The local oscillation signal is splitted into two signals and phase-shifted by a splitter and phase shifter 104 so that the split two oscillation signals are 90° out of phase. The mixers 5I and 5Q conduct frequency conversion of split two received signals outputted from the RF amplifier 20 by mixing them with two output signals from the splitter and phase shifter 104. Two received signals which have been subject to frequency conversion are amplified by intermediate frequency amplifiers 21I and 21Q and then are subject to frequency band limitation by low-pass filters 22I and 22Q for selecting desired signals. Two desired signals which have been selected by the low-pass filters 22I and 22Q are subjected to amplitude limitation depending upon the characteristics of a modulator by a limiter 23. Two desired signals having a limited amplitude are inputted to the demodulator 24 for demodulating the received signals and the demodulated signals are outputted from an output terminal 15 via a low-pass filter 25. In principle, the direct conversion receiver has features that frequency band limitation in a radio frequency band is not needed and the receiver may be readily manufactured from ICs since the frequency of the received signal after frequency conversion is low. For example, an IC for the direct conversion receiver is commercially available from Plessey Semiconductor Co., Ltd. as a Model "SL6637".

## SUMMARY OF THE INVENTION

Although above-mentioned prior art of the first and second receivers takes a measure for an over-input to the analog-to-digital converter 10, it takes no measure for an over-input to the RF amplifier 16 and the mixer 5. Accordingly, it invites various problems which will be hereafter described.

Input-to-output characteristics in automatic gain control at an intermediate frequency in the prior art as mentioned above will be described. Fig. 29 concerns with a system including the intermediate frequency band variable gain amplifier 7 which is subjected to a usual automatic gain control for illustrating the relation between the radio frequency input signal level at the input terminal 1 and the radio frequency input signal level at the intermediated frequency band variable gain amplifier 7. Abscissa denotes a radio frequency input level and ordinate denotes an intermediate frequency output level. Specifically, the levels correspond to the radio frequency input level at the radio frequency amplifier 16 and the intermediate frequency output level of the intermediate frequency variable gain amplifier 7 in Fig. 28, respectively. Description of unit in Fig. 29 is omitted since Fig. 29 is a schematic view.

When the radio frequency input level is low, the gain controller 8 does not carry out gain control to the intermediate frequency band variable gain amplifier 7, resulting in that linearity of the input-to-output characteristics is maintained until the radio frequency input level reaches A point as shown in Fig. 29.

When the radio frequency input level exceeds a point A, that is, the intermediate frequency reaches a point B, the level detector 9 and the gain controller 8 changes the gain of the intermediate frequency gain variable amplifier 7 so that the intermediate frequency output level will not exceed the point B. In this case, the basic operation of the automatic gain control comprises providing the gain controller 8 with information for lowering the gain of the IF band variable gain amplifier 7 when the IF output level which is detected by the level detector 9 exceeds a value corresponding to point B of the IF output level. The gain controller 8 receives information from the level detector 9 for operating the IF band variable gain amplifier 7 to lower the gain of the IF band variable gain amplifier 7. When the IF output level is lower than the point B by the above-mentioned gain control operation, the level detector 9 provides the gain controller 8 with information for increasing the gain of the IF band variable gain amplifier 7. Thus, the IF output level is fixed at the point B by the above-mentioned gain control loop. The IF output level may be fixed at the point B within the variable gain range of the IF band variable gain amplifier if the RF input level is above the point A. There will be transient areas of gain control before and after the point A in a practical circuit.

Since the above-mentioned automatic gain control is performed before selection of a desired signal, output level control is performed for mixed signals on a plurality of channels.

Accordingly, if the input level of a desired signal is low and the input level of received signals on other channels (hereafter referred to as undesired signals) is high, and the points A and B shown in Fig. 29 are preset at a low level, gain control of the IF band variable gain amplifier 7 is performed depending on the level of undesired signals, resulting in that the output level of a desired signal is suppressed as well as those of undesired signals and the reception sensitivity will be lowered. Therefore, the gain control range should be preset by considering decrease in sensitivity of the receiver.

Influence of inter-modulation will now be described. Amplification and frequency conversion of mixed received signals on a plurality of channels newly generates undesired signals due to inter-modulation. For simplicity of explanation, influence of inter-modulation will be described with reference to mixed signals including signals on three channels. It is assumed that a desired signal $D_1$ has a carrier frequency of $f_1$, undesired signals $y_1$ and $v_2$ have carrier frequencies $f_2$ and $f_3$, respectively, and the carrier frequencies are equally spaced and have a relation as follows:

$$f1 < f2 < f3$$
$$f3 - f2 = f2 - f1 = df$$

Only tertiary components are taken out from intermodulated signals generated with two undesired signals and may be represented as follows:

$$fi1 = 2f2 - f3 = f2 - df = f1$$
$$fi2 = 2f3 - f2 = f2 + df$$

The frequency of an inter-modulated signal on upper line fi1 is equal to the carrier frequency f1 of desired signal. The fixed signals of the desired and undesired signals and intermodulated signals are amplified by the IF band variable gain amplifier 7 after frequency-conversion at the mixer 5 and are converted into digital signals by the A/D converter 10 and then limited to a predetermined frequency band by the digital filter 11. The pass band of the digital filter 11 is preset to select desired signals and to eliminate undesired signals on other channels and inter-modulated signals outside of the pass band. However, inter-modulated signals having a frequency outside of the pass band of the digital filter will give an influence upon the limiter 12 and the modulator 14 at a subsequent stage since an inter-modulated signal (that is, fi1) having a frequency equal to that of a desired signal channel can not be eliminated by the digital filter. Therefore, countermeasure should be taken for suppressing the influence of the inter-modulated signals upon a modulation system within a predetermined allowance.

Such countermeasures include, for example, an approach of increasing a bias current for an amplifier. It will suffice to increase a bias current for improving linearity since the inter-modulation caused at an amplifier and a mixer is due to non-linearity of input-to-output characteristics. However, another countermeasure should be taken if a power consumption is considered. As an example, gain control of an RF amplifier may be expected. Instantly, gain control is applied to an RF amplifier as is similarly done by circuits 8 and 9 provided for an IF amplifier in Fig. 28. As a result, the output level of the RF amplifier will not exceed a level determined by gain control, and inter-modulation caused at the mixer 5 and the IF band variable gain amplifier 7 may be reduced.

However, a restriction similar to that described with reference to an automatic gain control of an IF amplifier is added to the above-mentioned gain control since an object of gain control is mixed received signals on a plurality of channels.

In order to overcome the restriction, it will suffice to detect a desired signal level and an RF circuit system is gain-controlled depending upon the detected level. However, if such a gain control circuit for detecting a desired signal level is independently provided in an RF system, the gain control circuit should comprise a filter for selecting only a desired signal from received signals on a plurality of channels, a level detector for detecting the desired signal level and a level discriminator for discriminating the detected signal levels, a gain controller and an RF variable gain amplifier. The most important and difficult component of the gain control circuit is a filter. Use of a narrow band filter for selecting only a desired signal from mixed signal on a plurality of channels at an RF band, is not effective in view of circuit scale and cost.

A direct conversion receiver which conducts an analog signal processing mentioned as second prior art includes variation factors such as deviation of device value, temperature characteristics and variation with time. Additional circuits for compensating for these factors are necessary and the number of points to be adjusted is large and this direct conversion receiver is not suitable for manufacturing from ICs. Digital circuits are advantageous in stability and provide a high versatility if they are used with a program processing. A direct conversion receiver using a digital signal processing is disclosed in, for example, JP-A-63-500766 (WO87/01531). In this publication, received signals at an RF band and advantages of digital signal processing is effectively used. However, conducting a fast A/D conversion and fast digital signal processing by the state-of-the-art circuit has problems in power consumption and cost.

It is a first object of the present invention to provide a radio receiver having a high sensitivity which does not require an increase in a bias current or a narrow band filter as mentioned above.

It is a second object of the present invention to provide a radio receiver having a high sensitivity which performs an analog and digital processing at RF and IF bands, and respectively, more specifically a radio receiver in which an automatic gain control having a frequency selectivity is possible by addition of relatively small circuits.

If an undesired signal having a level higher than that of a desired signal is included in the signal inputted into an IF band variable gain amplifier, gain control depending upon the level of undesired signal would be applied to the amplifier, which may suppress the desired signal, resulting in lowering in sensitivity of the receiver. Suppression of the undesired signal by provision of a low-pass analog filter at the previous stage of the IF band variable gain amplifier can prevent the IF band variable gain amplifier from lowering its gain caused by the undesired signal and can perform limitation of the level of an input to an A/D converter. However, provision of the low-pass analog filter enlarges circuit scale.

It is a third object of the present invention to conduct suppression of the level of an undesired signal inputted to an IF band variable gain amplifier and limitation of the level of an input to an A/D converter without enlarging the circuit scale.

In order to accomplish the first object, a radio receiver of the present invention comprises an RF amplifier having a variable gain for amplifying a frequency-modulated signal at an RF band which is inputted via an antenna, filter means for converting an IF band signal which has been converted from an output from the amplifier into a digital signal fallen within a predetermined intermediate frequency band, a modulator for modulating the digital signal, and control means connected with the filter means for controlling the gain of the RF amplifier depending upon the result of comparison of the output level of the digital signal with a predetermined reference level.

The radio receiver further includes input means for inputting data and a memory for storing the input data. The control means uses the data stored in the memory as a reference level when the output level of the digital signal outputted from the filter means is compared with the reference level.

The memory comprises a random access (or writable) memory on which writing is possible by the input means, and a read-only memory area on which a given data is preliminarily stored. The control means uses the data stored in the random access memory as a reference level when the data is stored in the random access memory area and uses the data stored in the read-only memory area as a reference level when the data is not stored in the random access memory.

The control means comprises a level comparator for comparing the level of a digital signal outputted from the filter means with a predetermined level which has been preliminarily stored, a memory for storing for a predetermined period of time the result of comparison outputted from the level comparator, and a control for switching the gain of the RF amplifier depending upon the result of comparison stored in the memory.

The above-mentioned filter means (digital filter) has a capability of selecting only a desired signal from mixed signals on a plurality of channels. Accordingly, the level of the signal outputted from the digital filter corresponds to the level of the desired signals. The aforementioned control means is capable of conducting automatic gain control depending on the level of the desired signal since the control means detects the level of the signal outputted from the digital filter and controls the gain of the RF amplifier depending on the detected level. The above-mentioned control means is capable of extending the dynamic range in response to an input level of the desired signal and improving the inter-modulation characteristics without lowering the reception sensitivity since it lowers the gain of the RF amplifier when the level of the desired signal becomes higher than the aforementioned reference level.

A radio receiver in which the gain of the receiver can be automatically controlled depending upon the level of a desired signal to provide an excellent over-input characteristics may be provided by adding a conventional receiver with relatively small scale circuits such as a level comparator for detecting the level of a signal outputted from the digital filter and a gain controller for controlling the gain of the RF amplifier depending on the level detected by the level comparator and by providing the RF amplifier with a gain controlling capability since a digital filter 11 and a digital level detector 13 have already been provided on the conventional receiver.

In order to accomplish the second object, a radio receiver of the present invention comprises an RF amplifier having a variable gain for amplifying a received signal with angle modulation at an RF band, a mixer which generates a local oscillation signal having a frequency approximate to the frequency of the received signal with angle modulation and splits the oscillation signal into two signals which are 90° out of phase from each other and converts the frequency of the signal outputted from the RF amplifier into a frequency in an IF band by using respective split signals, a processor for limiting the frequency of the IF band signal outputted from the mixer, a modulator for providing a demodulated output by using the output signal from the processor, and a gain controller for controlling the gain of the RF amplifier depending upon the level of the output signal from the processor.

Specifically, the processor comprises an IF band variable gain amplifier for amplifying an IF band signal output from the mixer, a low-pass analog filter which applies a frequency band limitation to an output signal from the IF band variable gain amplifier, an A/D converter for converting the output signal from the low-pass filter into a digital signal, a low-pass digital filter which applies a frequency band limitation to an output signal from the low-pass digital filter, and a high-pass filter which applies a frequency band limitation to an output signal from the low-pass filter. As a result, analog signal processing is applied to amplification at an RF band, frequency conversion and amplification at an IF band while digital signal processing is applied to filtering and demodulation.

The analog signal processor for the RF circuit system may be substantially identical with that used in a conventional direct conversion receiver. The IF amplifier system comprises an IF band variable gain amplifier, a level detector and a gain controller so that the gain of the IF band variable gain amplifier is changed through the level detector and the gain controller when an output signal from the IF band variable gain amplifier exceeds a preset level. This carries out limitation of the amplitude of the output signal of the IF band variable gain amplifier and limitation of the level of an input to the A/D converter. The low-pass analog filter disposed between the IF band variable gain amplifier and the A/D converter is adapted to eliminate aliasing frequency components inherent to digital signals. Digital signal processing is carried out

EP 0 413 311 A2

by using a two-system digital filter for selecting a desired signal, a digital level detector for detecting the level of a mixed signal including two desired signals, a limitter for limiting respective two desired signals by using an output of the digital level detector, a demodulator for demodulating a received signal by using two output signals of the limitter, and a digital filter for shaping the waveform of the demodulated signal.

The digital level comparator may be added with a writable memory circuit for changing information on the gain control of the RF band gain variable amplifier in response to an external signal or an internal signal.

In order to accomplish the other objects, a low-pass analog filter used for eliminating the aliasing frequency components of the digital signal is disposed at a pre-stage of the IF band variable gain amplifier in accordance with the present invention.

The present invention provides a direct conversion receiver by using a combination of analog and digital signal processing. The basic process of the present invention comprises the steps of converting the received signal, the frequency of which has been converted into a digital signal and demodulating the digital signal. Now an IF amplifier system will be described. The level detector always monitors an output of the IF band variable gain amplifier. When the level of the input signal is low, the gain of the IF band variable gain amplifier is fixed. When the input signal level is increased and, in turn, the level of the output signal from the IF band variable gain amplifier is increased so that it exceeds a reference level preset in the level detector, the level detector generates a signal to the level controller for lowering the gain of the IF band variable gain amplifier. The gain controller lowers the gain of the IF band variable gain amplifier in response to the signal from the level detector. The output signal level of the IF band variable gain amplifier assumes a given value corresponding to a reference level preset in the level detector by the above mentioned feedback loop. This accomplishes limitation of the level of the signal inputted to the subsequent A/D converter. Now, frequency band limitation by a low-pass analog filter will be described. Digital signal has a feature that a frequency characteristic is cyclic at a sampling cycle. Accordingly, on application of digital signal processing, at least frequency components not less than a half of the sampling cycle should be preliminarily removed. To this end, a low-pass analog filter is inserted for limiting a frequency band before a received signal is converted into a digital signal by an A/D converter. A low-pass digital filter is adapted to select only a desired signal from received signals on a plurality of channels and has capabilities similar to those of the low-pass analog filter in the prior art. A limiter will now be described. In a direct conversion receiver, demodulation is performed by using two desired signals having different phases. In order to perform a normal demodulation, it is necessary to limit the amplitude of the desired signal within an allowable input level of the amplifier. In a demodulator using digital signal processing of the present invention, limitation of the amplitude of the desired signal is carried out by using a combination of a digital level detector and a limiter. The digital level detector synthesizes two digital filter output signals and determines their levels. The limiter uses an output of the digital level detector for applying amplitude-limitation to two digital filter output signals. The demodulator demodulates two desired signals, the amplitude of which has been limited. Use of digital signal processing can provide a filter and a demodulating system which can be stably operated with respect to deviation of circuit constants, change in ambient temperature, variation with time and the like. The receiver consumes less power since the digital circuit is operated at a low frequency band.

A scheme for improvement in the above-mentioned inter-modulation characteristics in the present invention will now be described. In a direct conversion receiver, a desired signal is selected by conducting a frequency band limitation in a digital filter. Accordingly, an output of a digital level detector using a digital filter output signal corresponds to the level of the desired signal. Amplitude-limitation of respective desired signals is conducted by the limiter by using two digital filter outputs at I and Q sides. Switching of the gain of an RF amplifier responsive to an output signal from the digital level detector can lower the level of inter-modulated signals caused in the RF amplifier and a subsequent circuit system. A level comparator receives the output signal from the digital level detector for comparing it with a preset reference level and generates control information to a gain controller depending on a comparison result. The gain controller changes the gain of the RF band variable gain amplifier depending on comparison information from the level comparator. This makes it possible to control the receiver gain depending on the level of a desired signal without separately providing any filter. In order to carry out a gain control depending on the desired signal level in the present invention, it is necessary to provide an RF amplifier, the gain of which may be controlled and to add a level comparator and a gain controller. Addition of a small scale circuit makes it possible to automatically control the gain of a receiver depending on the desired signal level. Thus a receiver having an excellent over-input characteristics may be provided.

Addition of a memory circuit as an application of the present invention concerning a gain control depending on the desired signal level makes it possible to enhance freedom with respect to gain control. A reference level which is used for the level comparator is stored in the writable memory circuit. Gain control

7

characteristic is altered depending on the circumstances by changing the information stored in the memory circuit responsive to an external or internal signal.

It will suffice to apply a frequency band limitation before an IF band variable gain amplifier to prevent lowering in the gain of the IF band variable gain amplifier due to undesired signals and accompanying suppression of the desired signal. A direct conversion system needs a low-pass filter for suppressing only undesired signals, desired and undesired signals exist at low and high frequency band of the received signals, the frequency of which has been converted, respectively. Accordingly a low pass filter is necessary to suppress only undesired signals. However addition of a low-pass filter enlarges the circuit scale. Another scheme of the present invention is to dispose at a pre-stage of an IF band variable gain amplifier a low-pass analog filter used for eliminating aliasing frequency components of the digital signal. As a result of this, new addition of a low-pass filter is not necessary. Since an inherent object of the low-pass filter is to eliminate aliasing frequency components of a digital signal, a sampling frequency of the A/D converter determines a pass band of the low-pass analog filter. Channel selection is conducted by the digital filter in the direct conversion of the present inventions. To this end, the sampling frequency of the A/D converter is higher than that of the undesired signals included in the output signal of the IF band variable gain amplifier. Suppression of undesired signals may be accomplished simultaneously with elimination of aliasing frequency components of digital signal by disposing a low-pass analog filter at a pre-stage of an IF band variable gain amplifier and by making the pass band of the filter narrower than that determined by the sampling frequency.

The foregoing and other objects, advantages, manner of operation and novel features of the present invention will be understood from the following detailed description when read in connection with the accompanying drawings.

## BREIF DESCRIPTION OF THE DRAWINGS

Fig. 1 is a block diagram showing a radio receiver in which the present invention is embodied.

Figs. 2A and 2B are graphs showing an input-to-output characteristics of a receiver in which the present invention is embodied;

Fig. 3 is a graph showing an input-to-output characteristics of another embodiment of a receiver of the present invention;

Fig. 4 is a graph showing an input-to-output characteristics of a receiver including an RF amplifier having three gains in which the present invention is embodied;

Fig. 5 is a graph showing another input-to-output characteristics of a receiver including an RF amplifier having three gains in which the present invention is embodied;

Fig. 6 is a block diagram of a receiver realizing an input-to-output characteristics of the Fig. 4;

Fig. 7 is a block diagram showing a receiver suitable for an intermittent receiption in which the present invention is embodied;

Fig. 8 is a functional block diagram showing an embodiment of the present invention;

Fig. 9 is a circuit diagram of a splitter and phase shifter;

Fig. 10A and Fig. 10B are graphs for explaining electric characteristics of the splitter and phase shifter of Fig. 9;

Fig. 11 is a circuit diagram of a low-pass analog filter;

Fig. 12 is a circuit diagram of an A/D converter;

Fig. 13 is a circuit diagram of a decimation filter;

Figs. 14A through 14C are graphs explaining the frequency characteristics of the decimation filter of Fig. 13;

Fig. 15 is a circuit block diagram of a low-pass digital filter for selecting a desired signal;

Fig. 16 is a graph explaining the frequency characteristics of a low-pass digital filter of Fig. 15;

Fig. 17 is a circuit block diagram of a high-pass digital filter;

Fig. 18 is a graph explaining the frequency characteristics of the high-pass digital filter of Fig. 17;

Fig. 19 is a circuit block diagram of a limiter;

Figs. 20A through 20C are graphs showing the relation between I and Q signals outputted from the limiter;

Fig. 21 is a circuit block diagram of a demodulator;

Fig. 22 is a circuit block diagram of a demodulator including a simplified circuit;

Figs. 23A and 23B are graphs explaining the input-to-output characteristics of the embodiment shown in Fig. 8;

Fig. 24 is a graph explaining the input-to-output characteristics of another embodiment;

Fig. 25 is a circuit diagram of an RF band variable gain amplifier of the present invention;

Figs. 26 and 27 are functional block diagrams showing other embodiments of the present invention;

Fig. 28 is a block diagram showing a prior art radio receiver;

Fig. 29 is a graph showing the input-to-output characteristics of the prior art receiver of Fig. 28; and

Fig. 30 is a block diagram showing another prior art direct conversion receiver.

## DESCRIPTION OF THE PREFERRED EMBODIMENTS

A radio receiver which is a first embodiment of the present invention comprises an RF band variable gain amplifier 2 which is replaced with an RF amplifier 16 in the prior art receiver in Fig. 28, a level comparator 4 for comparing an output of a digital level detector 13 with a preset reference level, and a level controller which controls the gain of the RF band variable gain amplifier depending upon the output of the level comparator 4.

Operation of each components which have been mentioned will be described. The RF band variable gain amplifier 2 has different plural gains and is capable of selecting any one of the gains responsive to a signal from the gain controller 3. The level comparator 4 in advance stores a reference data and compares the reference data with the digital data outputted from the digital level detector 13 for providing the gain controller 3 with an instruction (data) for switching the gain of the RF band variable gain amplifier 2 depending upon a comparison result. The gain controller 3 receives the instruction (data) from the level comparator 4 for switching the gain of the RF band variable gain amplifier 2.

Since the output of the digital level detector 13 corresponds to the desired signal level, the above-mentioned system makes it possible to control the gain of the receiver depending on the desired signal level.

Specifically, the above-mentioned RF and variable gain amplifier 2 may comprise, for example, high and low gain amplifier and these amplifiers may be selectively switched. The RF band variable gain amplifier 2 uses the high gain amplifier when the level of the desired signal detected by the digital level detector 13 is lower than the preset reference level. The RF amplifier 2 uses the low gain amplifier when the level of the desired signal detected by the digital level detector 13 is higher than the reference level.

Input-to-output characteristics from an input terminal of the RF band variable gain amplifier 2 to an output terminal of an IF band variable gain amplifier 7 in relation to received mixed signals on a plurality of channels will be described with reference to two cases.

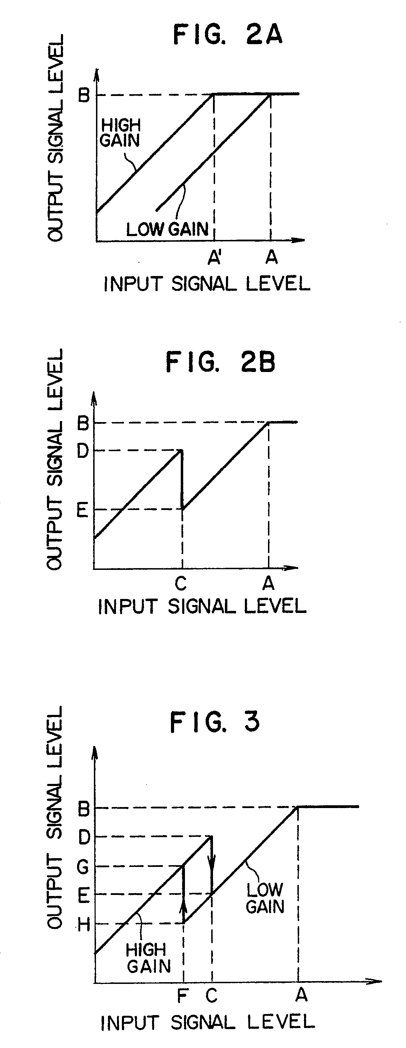

A first case is that only an input level of the undesired signal is changed while the input level of desired signal is kept constant. A second case is that only an input level of the desired signal is changed while the input level of the undesired signal is kept constant. The relation between the input level of the RF band variable gain amplifier 2 and the output level of the IF band variable gain amplifier 7 is shown in Fig. 2A. Since the level of the desired signal is constant in the above-mentioned first case, the undesired signal is eliminated by the digital filter 11 and the output signal of the digital filter 11 is only desired signal, resulting in a constant output level if the desired signal level is lower than a gain controllable level of the IF band variable gain amplifier 7.

For simplicity of description, influence of the fact that attenuation outside of the band of the digital filter is finite and influence of inter-modulation is omitted herein.

The output level of the digital level detector 13 is constant due to a fact that the output level of the digital filter 11 is constant as mentioned above. The result of comparison and determination by the level comparator 4 is also constant and the gain of the RF band variable gain amplifier 2 is fixed at any one of high or low gain. When the desired signal level is so low that the gain of the RF band variable gain amplifier 2 is preset to a high value, an increase in the undesired signal level causes the input-to-output signal characteristics to assume a curve denoted as "high gain" in Fig. 2A, which is linear until input level reaches at a point A'. When the undesired signal input level exceeds the point A', gain control of the IF band variable gain amplifier 7 commences so that the output level in relation to the input level not less than the point A' is constant at the point B. On the other hand, when the desired signal level is high and the RF band variable gain amplifier 2 is preset at a high gain, input-to-output characteristics in relation to the undesired signal level assumes an input-to-output characteristic curve represented as "low gain" in the drawing. In this case, the curve is linear until the input level reaches at the point A. When the input level exceeds the point A, gain control of the IF band variable gain amplifier 7 commences so that the output level in relation to the input level not less than the point A is constant at the point B.

An influence of gain control in the IF band variable gain amplifier 7 will be considered herein. Gain control in the IF band variable gain amplifier 7 has a characteristic that the gain will be lowered with increase in the input signal level for keeping the output level constant. Accordingly, if received signal is such that the undesired signal level is higher than the desired signal level and the desired signal level is constant, increase in the level of the received signal causes the desired signal level in the output signal of the IF band variable gain amplifier 7 to be substantially lowered. This also causes the output level of the digital filter 11 and the digital level detector 13 to be lowered. If the level comparator 13 determines that the desired signal level is less than a reference level when the received signal level is less than the point A, the determination result of the level comparator 13 would not change although the undesired signal level increases to lower the gain of the IF band variable gain amplifier 7, resulting in lowering of the desired signal level. Accordingly, the gain of the RF band variable gain amplifier 2 will not change and assumes respective input-to-output characteristic curves shown in Fig. 2A.

If the desired signal level is high and the level comparator 4 determines that the desired signal level is higher than a reference level, the determination result of the level comparator 4 will change when the desired signal level is lower than the reference level with lowering in the gain of the IF band variable gain amplifier 7. Hence, it is to be noted that it is necessary to preset a reference level in the level comparator 4 and the gain of the RF band variable gain amplifier 2 by considering a maximum input level of received signal so that the gain of the RF band variable gain amplifier 2 is not switched by a factor other than the desired signal level in the automatic gain control in the present invention.

Input-to-output characteristics in the second case will be described. Fig. 2B shows an input-to-output characteristic when only desired signal level is changed while undesired signal input level is kept constant. When the undesired signal level is lower than the desired signal level, the gain of the RF band variable gain amplifier is controlled depending upon the desired signal level since the undesired signal level is kept constant. In contrast to this, the level comparator 4 generates an output signal to the gain controller 3 to preset the gain of the RF band variable gain amplifier high when the desired signal level is so low that the level comparator 4 determines that the desired signal level is lower than a reference level. The level comparator 4 changes an output signal for the gain controller 3 to lower the gain of the RF band variable gain amplifier 2 when the desired signal level increases to exceed the reference level. The output level of the digital filter 11 is also constant since the output level of the IF band variable gain amplifier 7 is constant with respect to the desired signal level which exceeds the point A in the input-to-output characteristic curve in Fig. 2B. Accordingly, it is necessary to preset the reference level in the level comparator 4 to a value corresponding to the desired signal level lower than the point A as shown in Fig. 2B. In this case, the output level of the digital level detector 13 corresponding to, for example, a point C of the desired signal input level is preset as a reference level of the level comparator 4.

When the desired signal level is not higher than a point C1, the level comparator 4 determines that the desired signal level is not higher than the reference level and the RF band variable gain amplifier 2 is preset to a high gain. When the desired signal level exceeds the point C, the level comparator 4 changes the output signal for the gain controller to lower the gain of the RF band variable gain amplifier 2.

The gain controller 3 receives a signal from the level comparator 4 to switch the gain of the RF band variable gain amplifier 2. When the desired signal level increases to reach the point A, the gain of the IF band variable gain amplifier 7 is controlled so that the output level is fixed to the point B.

Since the output level will lower from a point D to a point E when the gain of the RF band variable gain amplifier 2 is switched to a low gain at the point C, the level of outputs from the digital filter 11 and the digital level detector 13 will also lower. As a result of this, the desired signal level in the level comparator 4 becomes not higher than the reference level. If the level comparator 4 is enabled at this time, the level comparator 4 generates a signal to the gain controller 3 to switch the gain of the RF band variable gain amplifier 2 to a high value so that gain control of the RF band variable gain amplifier 2 becomes unstable. Accordingly, the reference level of the level comparator 4 is changed to a value corresponding to the point E of the output level in Fig. 2B after the desired signal level exceeds the point C and the RF band variable gain amplifier 2 is switched to a low gain.

The above mentioned operation makes it possible to control gain depending on the desired signal level. An improvement in dynamic range of the desired input signal level by an value corresponding to a switching amount of the gain of the RF band variable gain amplifier 2 can be accomplished.

Since the gain of the RF band variable gain amplifier 2 is lowered in accordance with the present invention when the desired signal level exceeds a preset reference level, this will not gain any influence upon a demodulation system on input of a low level signal.

Inter-modulation characteristics can be improved since the gain of the RF band variable gain amplifier 2 is lowered when an over level signal is inputted. That is, inter-modulated signals generated in the mixer 5 and IF variable gain amplifier 7 are lowered by lowering the output level of the RF band variable gain amplifier 2. Further, circuit configuration may be changed for improving inter-modulation characteristics of the RF band variable gain amplifier 2 when the gain is low.

The differences between the present invention and the prior art reside in structure of the RF band variable gain amplifier 2 and addition of the gain controller 3 and the level comparator 4. The RF band variable gain amplifier 2 is smaller in scale in comparison with an RF band frequency selective gain controllable circuit including a filter and the like for selecting only a desired signal from received signals on a plurality of channels as mentioned above.

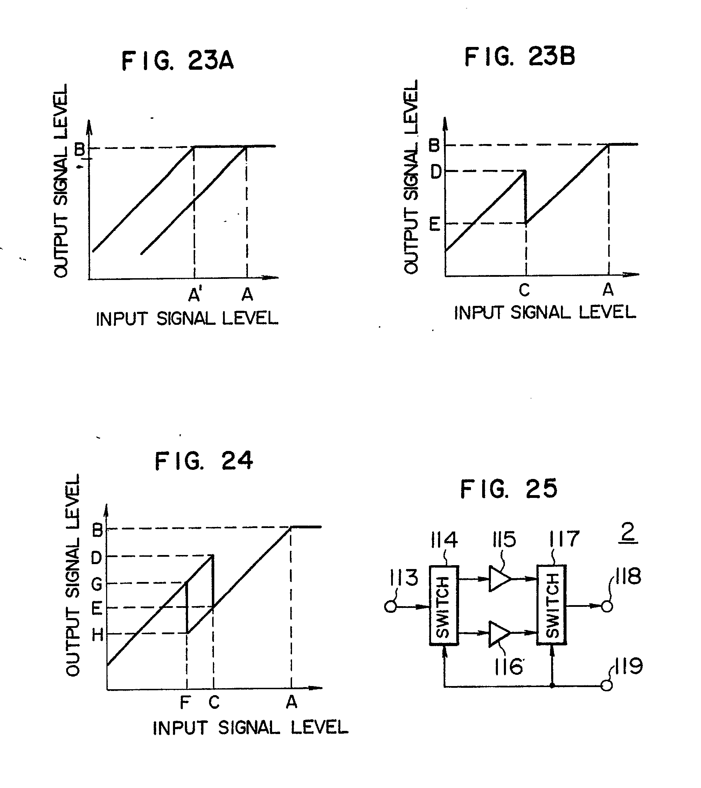

For example, there is an approach that the RF band variable gain amplifier 2 comprises two RF amplifiers which is switched as shown in Fig. 25. In Fig. 25, a high-gain amplifier 115 and a low gain amplifier 116 are disposed and input and output terminals are provided with switches 114 and 117, respectively, and any one of two amplifiers 115 and 116 is selected to connect in response to a signal from a control terminal 119. A wide dynamic range relative to a desire input signal can be assured by making much account of noise figure and characteristics at an over-input level in relation to high and low gain amplifiers 115 and 116, respectively.

The received signal level varies with time in a normal receiving state due to fading effect and the like. When the desired signal level varies below and above an input signal level corresponding to the point C in Fig. 2B, the gain of the RF band variable gain amplifier 2 should be frequently switched. As a result of this switching, the output level of the digital filter 11 frequently changes and transient phenomenon by gain switching is further added so that these will give an adverse influence upon a subsequent demodulation system. An embodiment for avoiding this will be described with reference to an input-to-output characteristic curve in Fig. 3.

Points A, B, C, D, and E in the graph of Fig. 3 are identical with corresponding points shown in Fig. 2B. Operation of the RF band variable gain amplifier 2 when the desired signal input level reaches the point C is identical with that of the above mentioned embodiment. Presetting of the reference level in the level comparator 4 when the gain is low is changed from the point E in the first embodiment to a point H. If the desired signal input level is lowered after the RF band variable gain amplifier 2 has been rendered a low gain, the gain of the RF band variable gain amplifier 2 would be fixed until the input level reaches a point F. When the input level becomes lower than the point F, the level comparator 4 provides the gain controller 3 with a gain switching signal to change the gain of the RF band variable gain amplifier 2 to a high gain. This provides a marginal range between the points C and F in Fig. 2B so that instability in gain control caused by change in level due to fading effect and the like may be avoided.

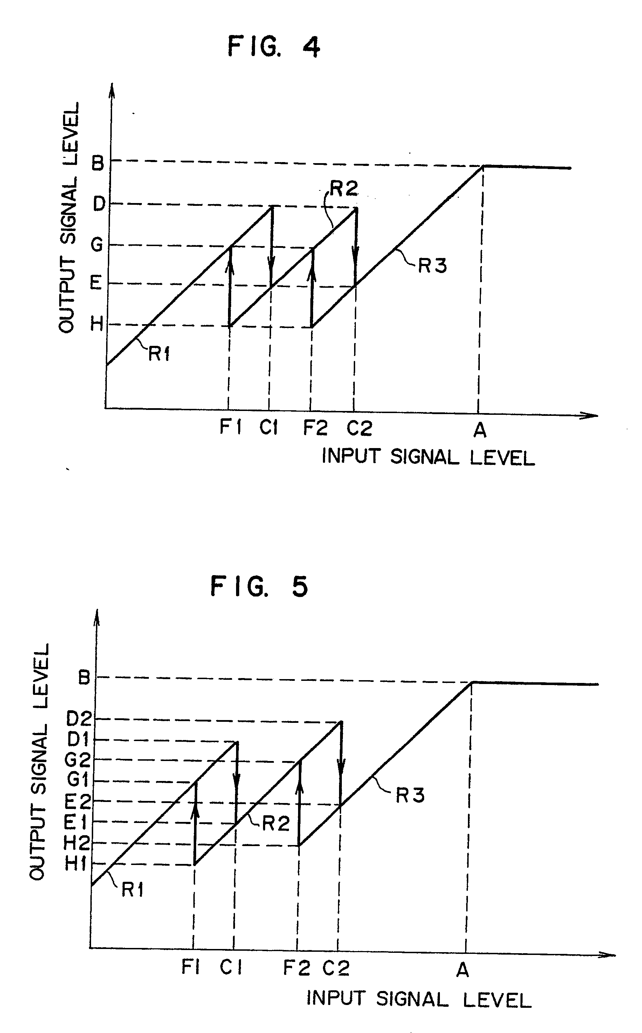

An embodiment in which the above mentioned RF band variable gain amplifier 2 has a plurality of gains and one of gains is selected will now be described. Input-to-output characteristics in the case that one of three gains, such as high, medium and low gains of the RF band variable gain amplifier 2 is selected is shown in Fig. 4.

The gains of the RF band variable gain amplifier 2 are represented as R1, R2 and R3 (R1 > R2 > R3) and it is assumed that the three gains are changeable. Operation when the desired signal input level is gradually increased will be described. The gain of the RF band variable gain amplifier 2 is preset to R1 when the desired signal level is minimum. When the desired signal level increases to reach the point C1, the output signal of the level comparator 3 changes so that the gain of the RF band variable gain amplifier 2 is changed from R1 to R2 via the gain controller 4. At this time, the output level changes from the point D to the point E. When the input level increases to reach a point C2, the output signal of the level comparator 4 changes again so that the gain of the RF band variable gain amplifier 2 is changed from R2 to R3. At this time, the output level changes from the point D to E. When the input level further increases to exceed the point A, the gain of the IF band variable gain amplifier 7 is controlled so that the output level is fixed to the point B. Operation when the input level is decreased will now be described. If the input level is not higher than the point A, the output level is at the point B and the gain of the RF band variable gain amplifier 2 is R3. When the input level is decreased to reach a point F2, the gain of the RF band variable gain amplifier 2 is changed from R3 to R2 and the output level is changed from the point H to a point G at this time. When the input level is further decreased to reach a point F1, the gain of the RF band variable gain amplifier 2 is changed from R2 to R1 and at this time, the output level is changed from the point H to G. Ranges between C1 and F1 and between C2 and $F_2$ on the input signal level will be margin for changes in the input level due to fading effect and the like.

In order to realize such an input-to-output characteristics, values corresponding to the points D and H are preset as reference level preset values in the level comparator 4. It is necessary to change the circuit of the level comparator 4 since the RF band variable gain amplifier 2 has three gains to be selected. It is also necessary to change the circuit of the gain controller 3 since the number of gains to be selected are three.

The output level is same with respect to twice switching of gain in the above mentioned input-to-output characteristics. The gain of the RF band variable gain amplifier 2 could be switched at different output levels if the reference levels in the level comparator 4 are separately preset for low and high input levels. Input-to-output characteristics in this case is shown in Fig. 5. Since input signal levels C1 to C2, F1 to F2 and gains R1 to R3 (R1 > R2 > R3) in Fig. 5 is identical with those in Fig. 4, description of them will be omitted.

As shown in the drawings, an output level C1 of the input signal and an output level (D2) when the gain is changed from R2 to R3 at the level C2 of the input signal has a relation D1 < D2. The relation between output levels H1 and H2 when the gain is changed from R2 to R1 and R3 to R2 at the input signal levels F1 and F2, respectively, is such that H1 < H2. In this case, the level comparator 4 can preset a reference level for each gain.

If the gain can be switched depending on the output signal level by providing the RF amplifier 2 with a plurality of gains, dynamic range relative to a desired signal level could be further extended and inter-modulation characteristics could be improved.

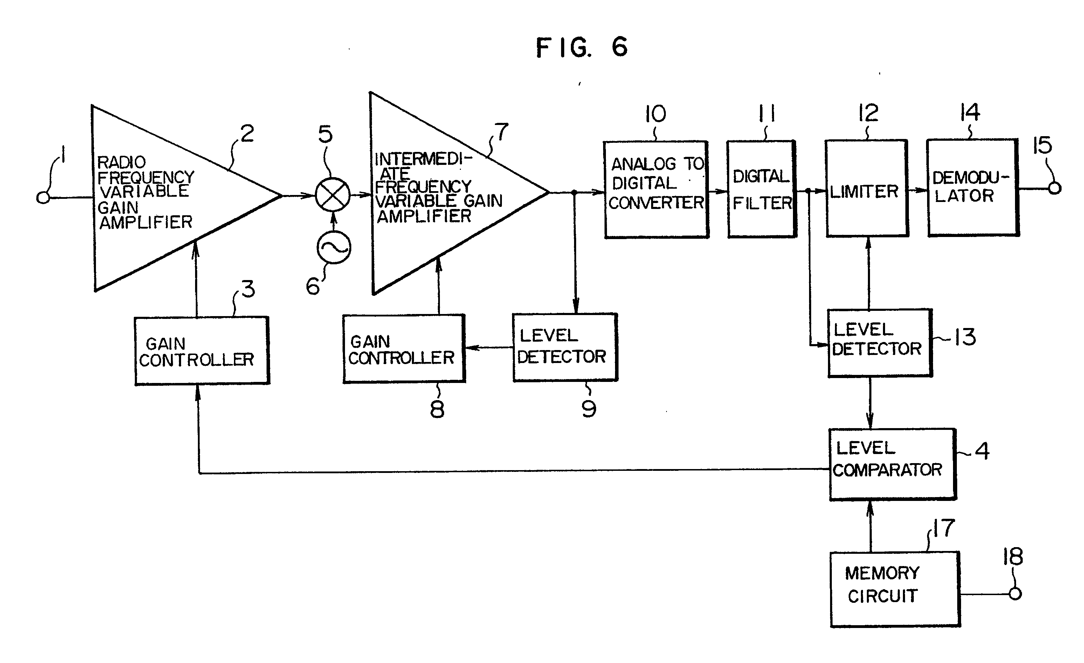

A second embodiment of the present invention in which reference levels which are to be preset for the above mentioned level comparator 4 and be freely preset will be described with reference to Fig. 6.

It is effective to preliminarily store reference levels to be preset in the level comparator 4 as fixed data in view of circuit scale. However, it is also effective that the input-to-output characteristics can be changed responsive to an external signal according to purposes if versatility of level comparison and gain control attendent thereon is considered.

Fig. 6 is a block diagram showing a receiver which is added with a memory circuit 17 which is writable by an external signal via a control input terminal 18.

The memory circuit 17 is writable so that memory information may be written via a control signal input terminal 18 from a keyboard and the like connected to an external device for storing reference levels used in the level comparator 4. It is desirable that the memory circuit 17 can hold memory information even if power to other circuits is turned off. The level comparator 4 generates gain control information to the gain controller 3 by using reference levels stored in the memory circuit 17 and the output from the level detector 13. As a result of this, gain control may be changed according to circumstances. A part of the memory circuit 17 comprises a read-only-memory in which basic information is stored. Gain control may be carried out by using, as reference levels, the basic information stored in the read-only memory unless information is inputted to the writable memory by an external signal.

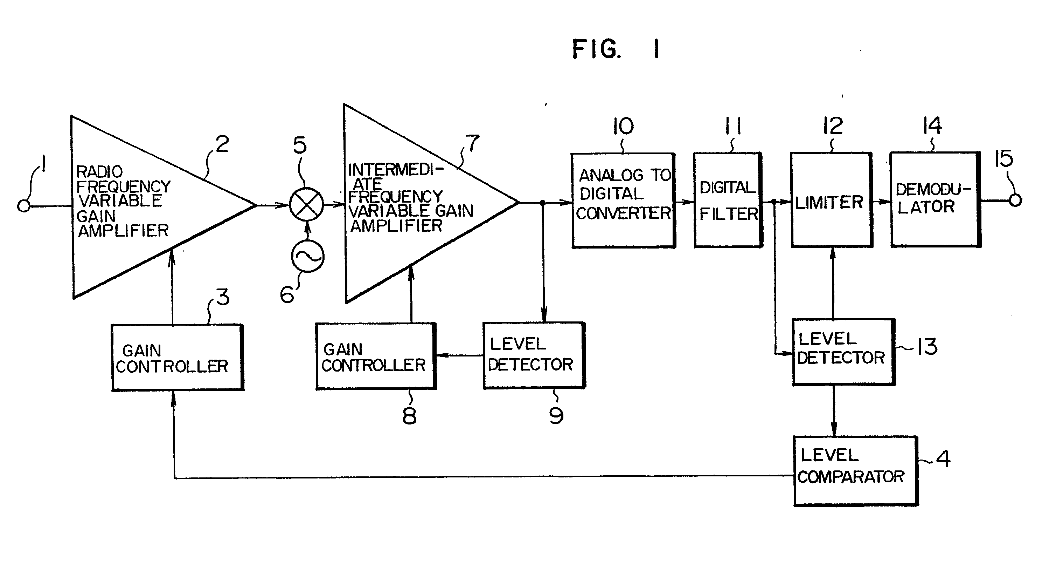

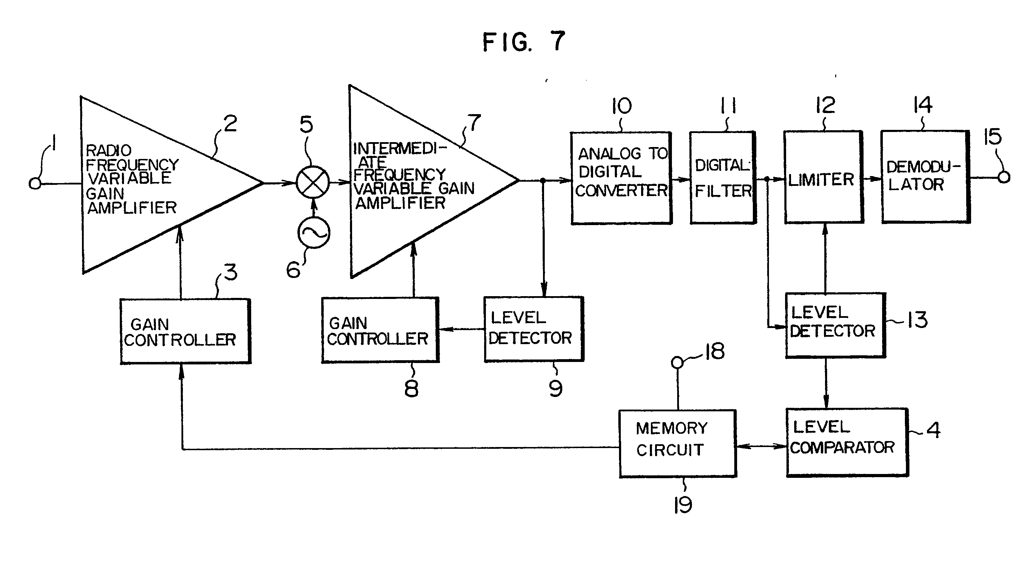

An intermittent receiving performed by the above mentioned receiver will now be described. An intermittent receiving is a receiving mode in which receiving and pause states are alternatively repeated at a preset period of time. Depending on the system and the terminals, various schemes are available as the state of the receiver in a pause state. As a typical example, the receiving part except for the control part is turned off. Accordingly, the gain of the above mentioned RF band variable gain amplifier will be returned to an initial level once the receiver is brought into a pause state unless a special function is added. The desired signal level scarcely abruptly changes on intermittent receiving for a relatively short period of time. Therefore, when the receiver is brought into a pause state from a receiving state and then brought into a pause state, there is a strong likelihood that the desired signal level is approximate to that in the previous receiving state. Accordingly, gain control can be quickly commenced when the receiver is brought into next receiving state by storing information on gain control in the previous receiving state until next receiving state. Fig. 7 is a block diagram showing a third embodiment of a receiver which performs the above mentioned intermittent receiving. The difference between the third embodiment and the first embodiment in Fig. 1 resides in a memory circuit 18. The memory circuit 18 comprises a writable memory circuit which can hold stored information even if a power source for radio receiver is turned off. The memory circuit 18 receives and transmits information from and to the level comparator 4. Information outputted from the level comparator 4 is stored in the memory circuit 18. The gain controller 3 changes the gain of the RF band variable gain amplifier 2 depending on the information stored in the memory circuit 18. When the receiver is brought into a pause state, a power source for circuit other than the memory circuit 18 is turned off. At this time, information on gain control stored in the memory circuit 18 is held. When the receiver is brought into a receiving state, the gain controller 3 changes the gain of the RF band variable gain amplifier 2 to the gain in previous receiving state by using gain control information stored in the memory circuit 13. On the other hand, the level comparator 4 determines which gain the RF band variable gain amplifier 2 assumes with reference to gain control information stored in the memory circuit 18 and selects a reference level used for level comparison.

In accordance with these embodiments, a radio receiver having a high sensitivity can be realized. Since the above mentioned radio receiver controls its gain by using an output of a digital filter, it can realize a frequency selective gain control by adding a conventional radio receiver with a small scale circuit without increasing a bias current and provision of a narrow band pass filter. If the reference levels in the level comparator can be preset in response to an external signal, freedom of input-to-output characteristics in relation to a desired signal would become high. A high versatility could be provided if a circuit for realizing frequency selective gain control is incorporated in a receiver or is formed of ICs. If gain control information in previous receiving state in an intermittent receiver is stored and is used when the receiver is brought into next receiving state from a pause state, a rise-up time of gain control when the receiver is brought into a receiving state could be shortened.

The present invention will be described by way of an embodiment of a radio receiver using a direct conversion. Like reference numerals in the drawings, which are identical with those in Fig. 1, etc. represent circuit having like function.

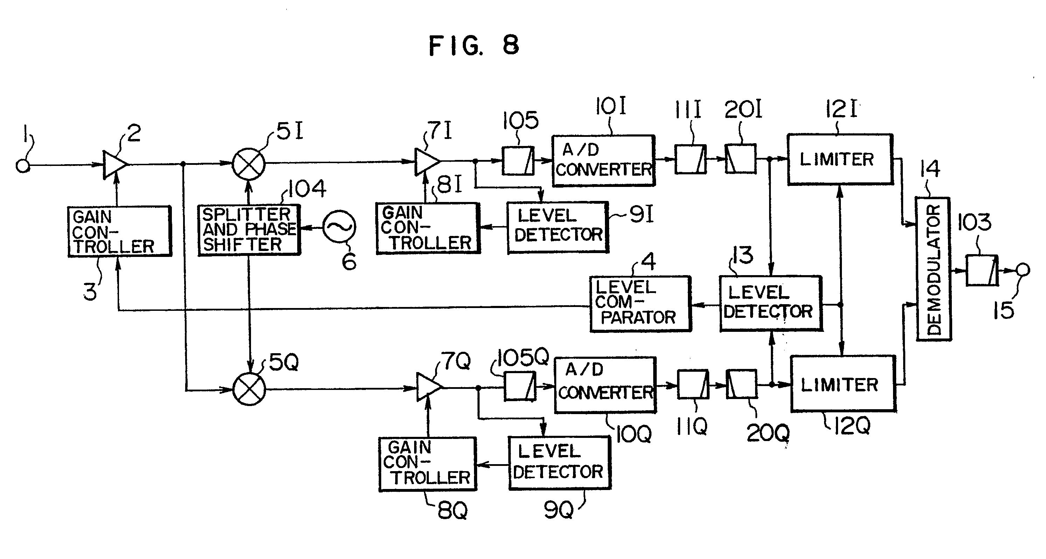

Now a fourth embodiment of the present invention will be described with reference to Fig. 8. A received signal which is inputted to an input terminal 1 is amplified by an RF band variable gain amplifier 2 and then split into two signals. The received signals after splitting pass through identical two processing systems, respectively. The received signals passing through upper and lower processing systems in Fig. 8 will be hereafter referred to as signals I and Q, respectively. Only processing of signal I will be described while description on processing of signal Q will be omitted since processing of both signals I and Q is identical with each other. A local oscillator 6 generates a local oscillation signal having an oscillation frequency substantially equal to a carrier frequency of a desired reception signal. After a splitter and phase shifter 104 splits the local oscillation signal into two signals, it shifts the phase of the split local oscillation signals by $90°$. A mixer 5I (5Q) converts the frequency of a signal I into an intermediate frequency (IF) by mixing it with an output signal from the splitter and phase shifter 104. An output signal of the mixer 5I (5Q) is amplified by an IF band variable gain amplifier 7I (7Q). The level of an output signal of the IF band variable gain amplifier 7I (7Q) is detected by a level detector 9I (9Q) and the gain of the IF band variable gain amplifier 7I (7Q) is changed depending on the detected level via a gain controller 8I. Thus, the output level is controlled so that it does not exceed a preset value when the level of the input signal to the IF band variable gain amplifier 7I (7Q) is high. The output signal of the IF band variable gain amplifier 7I (7Q) is converted into a digital signal by an A/D converter 10I (10Q) after it is subjected to frequency band limitation at a low-pass filter 105I (105Q). An output signal of the A/D converter 10I (10Q) is subjected to frequency band limitation at a low-pass digital filter 11I (11Q) and a high-pass filter 20I (20Q). The digital level detector receives two output signals from the high-pass digital filters 20I and 20Q for detecting the level of mixed signals including signals I and Q. The amplitude of the output signal of the high-pass digital filter 20I (20Q) is limited by using an output of the digital level detector 13. The output signals from two limiters 12I and 12Q are applied to a demodulator 14 for demodulating the signals. An output signal from the demodulator 14 is subjected to frequency band limitation at a low-pass digital filter to provide a demodulated output. The gain of the RF band variable gain amplifier 2 is changeable to not less than two value responsive to a control signal from the gain controller 3. The level comparator compares a reference value which is preset with an output level of the digital level detector 13. The gain of the RF band variable gain amplifier 2 is changed through the gain controller 2 depending upon a result of comparison.

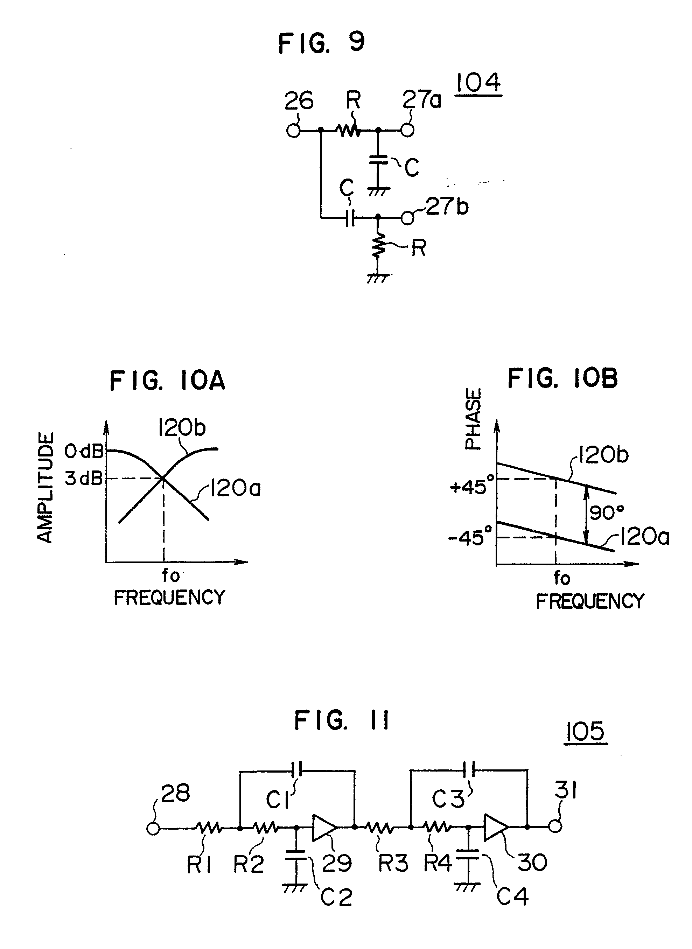

Each part of the receiver will be described in detail by way of a FSK (Frequency shift Keying) signal having an RF frequency of 300 MHz band, a channel interval of 12.5 KHz, the number of channels of 20, a modulation degree of ±2.5 KHz, and a modulated frequency of 200 Hz. Firstly, operation and circuit configuration of the receiver will be described and gain control, a gist of the present invention will be then described. Received signals on all the channels are inputted to an input terminal 1 via an antenna. An RF band variable gain amplifier requires a frequency band width equal to at least 20 channels (that is 250 KHz) having a central frequency within a 300 MHz band. Various characteristics for the amplifier are determined by the specifications of the receiver and each circuits in the receiver. A local oscillator 6 is adjusted to generate an oscillation signal having a frequency to a carrier frequency of a reception desired channel. The local oscillator 6 may be an oscillator having a single oscillation frequency if the receiving channel is preliminarily fixed while it may comprise an oscillator having a variable oscillation frequency to which a control signal is applied for adjusting the oscillation frequency to a reception desired channel's frequency. A splitter and phase shifter 104 an oscillation signal generated by the local oscillator 6 splits the local oscillation signal into two signals and shifts the phase of the two local oscillation signals by $90°$ from each other. An example of the circuit of a splitter and phase shifter 104 is shown in Fig. 9. The local oscillation signal is applied to an input terminal 26 in Fig. 9. After splitting into two signals, outputs determined by a circuit constant of CR (C: capacitor, R: resistor) is provided at output terminals 27a and 27b. For simplicity of description, description of an influence of signal source impedance on the input terminal 26 and an influence of load impedance on output terminals 27a and 27b will be omitted. Frequency characteristics of the splitter and phase shifter of Fig. 9 is shown in Figs. 10A and 10B. Fig. 10A shows amplitude characteristics and Fig. 10B shows phase characteristics. Phase difference of the output signals which are

13

obtained at the output terminals 27a and 27b in the splitter and phase shifter of Fig. 9 is 90° independently of the signal frequency. In the direct conversion receiver, an absolute phase of the local oscillation signal does not matter. On the other hand, amplitude characteristic has a frequency characteristic determined by a CR product. The output levels at the output terminals 27a and 27b become equal with each other when fc = $\sqrt{CR}$ /$2\pi$, which is -3 dB output voltage with respect to an input level. Therefore, a CR product is determined so that fc = a receiving channel's frequency, if the receiving channel is fixed to a given frequency. On the other hand, a level difference arises with respect to two local oscillation signals. In an alternative configuration of the splitter and phase shifter 104, after splitting the local oscillation signal, only one split signal may be phase-shifted by 90° while the other signal may not be shifted to provide 90° phase difference between two split signals. In practice, a buffer amplifier is inserted into the splitter and phase shifter and/or CR constant is compensated for in order to eliminate influences of signal source impedance or load impedance and signal pick-up between the output terminals 27a and 27b. The mixer 5I (5Q) converts the frequency of received signal, an output from the RF amplifier which has been split, by mixing it with the output signals of the splitter and phase shifter 104. Specifically the mixer may includes various circuits such as double balanced mixer, single end mixer. A feature of the direct conversion receiver resides in that a carrier frequency of the received signal after frequency-conversion is 0 Hz. As a result, an output signal of the mixer 5I (5Q) is within a low frequency band including a direct current. A desired signal frequency is 2.5 KHz under the above-mentioned conditions.

An IF band variable gain amplifier 7I (7Q) comprises amplifier for a low frequency band including a direct current for amplifying the output signal from the mixer 5I (5Q). The IF amplifier is added with an automatic level control capability in order to limit the level of the input signal to a subsequent A/D converter 10I (10Q). An output signal of the IF band variable gain amplifier 7I (7Q) is inputted into a level detector 9I (9Q) uses, for example, a diode detecting circuit for detecting an input signal level and compares the detected input signal level with a preset reference level. When the input signal level exceeds the reference level, the detector requests a gain controller 8I (8Q) to lower the gain of the IF band variable gain amplifier 7I (7Q). The gain controller 8I (8Q) receives a signal from the level detector 9I (9Q) to decrease the gain of the IF band variable gain amplifier 7I (7Q) by an operation such as change in a bias current to the IF band variable gain amplifier 7I (7Q). The level detector 9I (9Q) detects the output signal level of the IF band variable gain amplifier 7I (7Q), the gain of which has been changed and continues to instruct the level controller to change the gain of the IF band variable gain amplifier 7I (7Q) until the input signal level to the detector will reach the reference level. By the above mentioned feedback system, the output level of the IF band variable gain amplifier 7I (7Q) is suppressed within the reference level preset in the level detector 9I (9Q). This limits the level of the input to the A/D converter 10I (10Q) so that the A/D converter 10I (10Q) can normally operate. On the other hand, when the input signal level is lower than the reference level, the detector does not request to change the gain of the IF band variable gain amplifier 7I (7Q) till the signal level is lower than the other predetermined reference level.

Digital signal has a feature that a frequency characteristic is cyclic at a sampling cycle. By means of digital filter, a repeating frequency characteristic is exhibited with respect to a signal having a frequency band exceeding a sampling frequency. Accordingly, it is necessary to preliminarily eliminate a frequency component exceeding a half of the sampling frequency on filtering the signal. Since similar characteristic is also exhibited in an A/D converter after sampling, it is necessary to limit the frequency band of the signal before inputting to the converter. A low-pass analog filter 105I (105Q) has a capability to prevent an aliasing noise of the digital signal, caused in the subsequent A/D converter 10I (10Q). If it is assumed that the sampling frequency of the digital signal be 32 KHz under the above-mentioned input signal conditions, a maximum frequency which may be processed by the digital filter would be 16 KHz. If it is assumed that the sampling frequency of the A/D converter 10I (10Q) be 32 KHz, it would be necessary to provide a low-pass filter 105I (105Q) having 16 KHz or more stop band. In this case, an advantage of a digital system is not taken since a frequency characteristic required for the low-pass analog filter 105I (105Q) becomes more severe. Use of an over sampling type A/D converter is effective to reduce the requirements for the low-pass analog filter 105I (105Q). The over sampling type A/D converter consecutively lower the sampling frequency after A/D conversion at a higher sampling frequency. A feature of the over sampling type A/D converter resides in that it can distribute a quantum noise caused in the converter so that it is low in a low frequency band while it is high in a high frequency band. Combined use of filtering when the sampling frequency is lowered provides a substantially low noise. However it is preferable that the sampling frequency be low in view of circuit scale and power consumption. The sampling frequency of the A/D converter 10I (10Q) is 512 KHz as an example under the above mentioned signal condition. Therefore, the stop hand fa of the low-pass analog filter 105I (105Q) is 256 KHz and higher. A stop band attenuation Aa is determined by specifications given to the receiver, for example, 90 dB. The frequency of the reception desired signal is 2.5 KHz as mentioned above. A pass band fc of the low-pass filter is 8 KHz in consideration of constant variation of an analog circuit and the like, and selection of a desired signal at the subsequent digital filter. The number of orders of the filter required for the low-pass analog filter is determined from above constants as follows:

$N = (Aa/6)/\{\log(fa/fc)/\log 2\}$
$= 3$

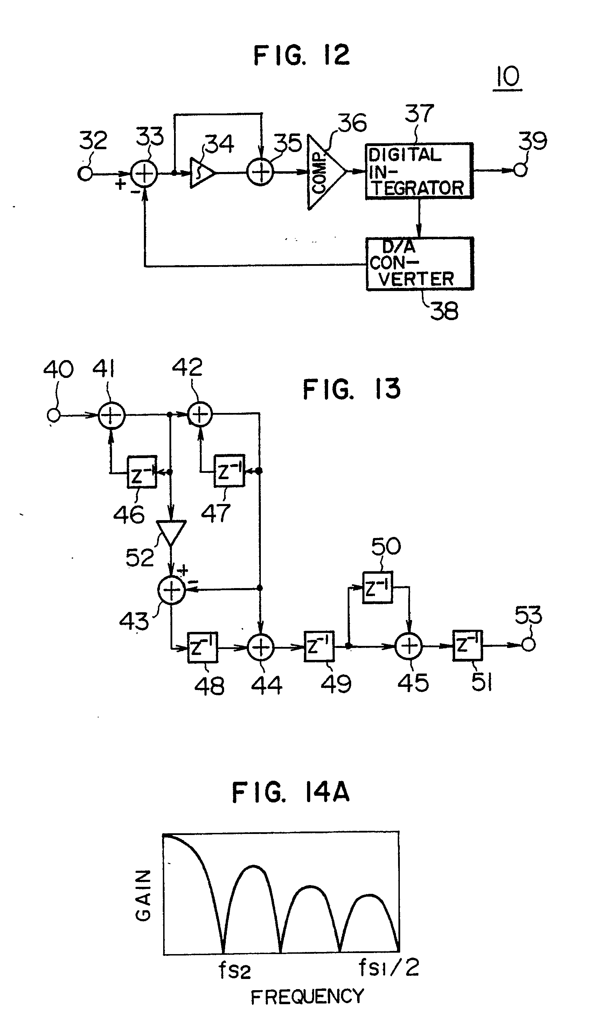

An example of a low-pass filter is of four order structure for leaving a margin is shown in Fig. 11. The low-pass filter of Fig. 11 comprises two order Sallen-Key filters which are cascaded over two stages. If the gain of the amplifiers 29 and 30 is 1, the gain of the band pass filter would be 1. Values of circuit constants R1 through R4, C1 though C4 are determined by a required frequency characteristic.

An example of an over sampling A/D converter will now be described. The over sampling A/D converter comprises an A/D converting portion which operates at a high sampling frequency and a decimation filter which sequentially lowers the sampling frequency. An example of the A/D converting part is shown in Fig. 12. The embodiment will be described by assuming that the sampling frequency be 512 KHz. An analog signal is applied to an input terminal 32. An analog adder 33 determines a difference between a current input signal and an output signal at a previous sampling time from the A/D converter. This adder is an analog circuit, the previous output signal from the A/D converter is converted into an analog signal by the D/A converter 38. An analog integrator 34 has integrated outputs until previous outputs of the analog adder. A sum of an output of the analog adder 33 and the current difference is determined by the analog adder 35. The output of the analog adder 35 is compared with a preset reference value in the comparator 36, which outputs a digital data depending upon comparison result. The digital integrator 37 integrates the digital data from the comparator 36 for providing an output to the A/D converter. The digital data is inputted to a subsequent decimation filter through an output terminal 39. An output signal of the A/D converter is converted into an analog signal by a D/A converter 38 and then inputted to the analog adder 33. The above mentioned operation is repeated at each sampling frequency 512 KHz, that is, 1/512 KHz, 2 $\mu$ seconds. Assuming the output of the A/D converter be a predicted value at previous cycle, the output result of the analog adder 33 represents an error between the predicted value and a true value. The output of the analog integrator 34 is a build up value of error until previous cycle. Accordingly, the output of the analog adder 35 represents a sum of build up error value and an error at present cycle, that is build up error value until the present cycle. The comparator 36 predicts an error at previous cycle from the build up error value until present period. There are various combinations of a reference value used for the comparator 36 and an output data to the digital integrator 37. The output data of the comparator 36 is ±1 as a most simple example. In this case, the reference value used for the comparator is 0. That is, if the input signal level is positive (error build up value is positive), the comparator 36 would output a signal to decrease the output of the A/D converter, that is, -1. On the other hand, if the input signal level is negative, the comparator outputs + 1. In this case, the digital integrator 37 may be converted so that it comprises a bi-directional counter for reducing circuit scale and power consumption. The decimation filter will now be described with reference to Figs 13. The object of the decimation filter is to lower the sampling frequency of the output signal of the A/D converter, in principle, to average output data of the A/D converter. Lowering the sampling frequency by simply averaging raises a problem in the above mentioned aliasing noise. A feature of the decimation filter resides in a frequency band limiting capability for suppressing the aliasing noise caused on changing the sampling frequency. An example of the decimation filter under the above mentioned sampling frequency conditions, that is, an input signal sampling frequency of 512 KHz and an output signal sampling frequency of 32 KHz is shown in Fig. 13. The digital data is inputted to an input terminal 40 from the A/D converting portion. Both shift registers 46 and 47 are one bit shift circuit having a sampling frequency (512 KHz) equal to that of the A/D converting portion which resets data content for each intermediate sampling period. In case shown in Fig. 13, the intermediate sampling frequency is 64 KHz. An adder 41 adds an input data and an output data of the shift register 46. Accordingly, a combination of the adder 41 and the shift register 46 functions as a digital integrator to the input data. Since the data of the shift register 43 is reset for each intermediate sampling period, the circuit of Fig. 13 will integrate 8 (= 512 KHz/64 KHz) items of input data. A combination of the adder 42 and the shift register 47 also functions as a digital integrator and repeats addition of 8 items of data. A multiplier 52 multiplies an output data of the adder 41 with a constant for each intermediate sampling period. The constant is the number of items of data for a sampling period, which is eight herein. Since the constant is the third power of two, practically the multiplier may comprise a three bit level shift circuit. In such a manner, in order to make circuit scale less, it is advantageous that number of conversion steps of the sampling frequency is selected as a power of two. The adder 43 subtracts the output data of the adder 42 from the output data of the multiplier 50 for each intermediate sampling period. A shift register 48 functions as a delay circuit for providing a delay of an intermediate-sampling frequency. The adder adds the output data of the shift register 48 with the output data of the adder 42 for each intermediate sampling period. A shift register functions as a delay circuit which receives an output of the adder 44 as an input data for providing a delay of an intermediate-sampling period and compensates for a timing of subsequent processing by considering an influence of a delay time of the adder 44. A transfer function from the input terminal 40 to the output terminal of the adder 44 in the above mentioned decimation filter are summarized by following formula.

$$H(Z) = 1 + 2Z^{-1} + 3Z^{-2} + 4Z^{-3} + 5Z^{-4} + 6Z^{-5} + 7Z^{-6} + 8Z^{-7} + 7Z^{-8} + 6Z^{-9} + 5Z^{-10} + 4Z^{-11} + 3Z^{-12} + 2Z^{-13} + Z^{-14}$$

A shift register 50 functions as a circuit for providing an intermediate sampling period. The adder 45 adds the output data of the shift register 45 to the output data of the shift register 50. The shift register 51 holds the result of the adder 45 and functions as a circuit for providing a delay as long as twice the intermediate sampling period and outputs every one result of the adder 45 to an output terminal 51. Since the intermediate sampling frequency of a final data is 32 KHz. A transfer function from the output of the shift register 49 to an output terminal 53 is represented as follows:

$$H(Z) = 1 + Z^{-1}$$

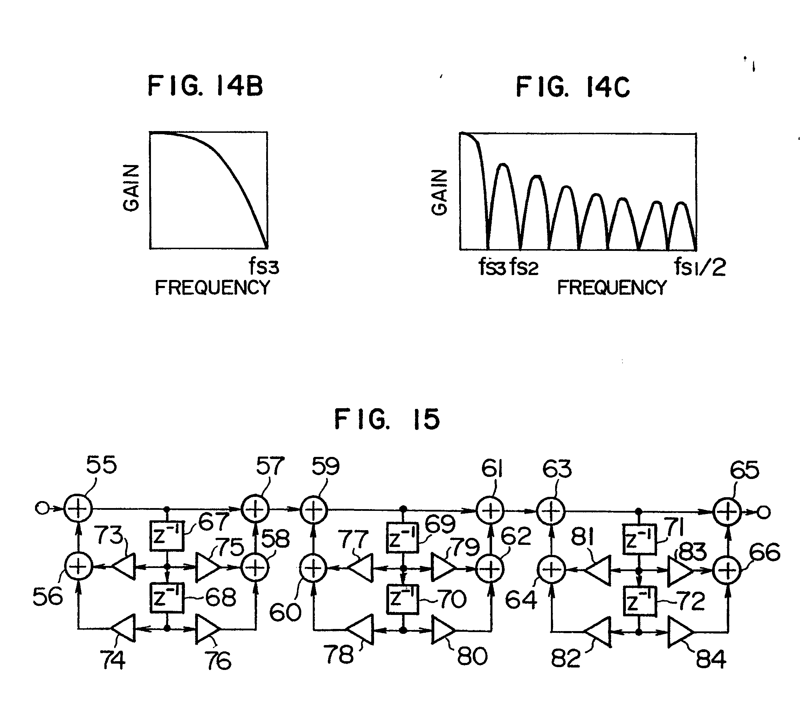

A frequency characteristic of the decimation filter is shown in Figs. 14A through 14C. Fig. 14A shows a frequency characteristic from the input terminal 40 to the output of the shift register 49. fs1 corresponds to a sampling frequency of an output signal and is 512 KHz. fs2 corresponds to an intermediate sampling frequency and is 64 KHz. The frequency characteristic has a feature that it has a zero point at an interval of 64 KHz by the first decimation filter. Fig. 14B shows a frequency characteristic from the output of the shift register 49 to the output of the shift register 51. fs3 corresponds to a half of the intermediate sampling frequency and is 32 KHz. The frequency characteristic of latter decimation filter has a feature that it has a zero point at an interval of 32 KHz. A frequency characteristic of the whole of the decimation filter is shown in Fig. 14C. A sampling frequency of a subsequent low-pass filter is 32 KHz. The decimation filter provides a stop band at an interval of 32 KHz since a pass band is generated at an interval of 32 KHz. As shown in Fig. 14C, the decimation filter has cyclically pass bands within a frequency band not less than 32 KHz. With respect to this, a whole filter characteristic can be synthesized by corresponding to a stop band of subsequent low pass digital filter. If a more sharp frequency characteristic is required for processing at an intermediate sampling frequency band of Fig. 14B, an improvement by connection of a multiple of digital filters, each comprising the shift register 50 and the adder 45 in Fig. 13 or insertion of a digital filter having an intermediate sampling frequency is possible.

An example of the low-pass digital filter 11I (11Q) of Fig. 8 will be described in detail. The low-pass digital filter 11I (11Q) is operated for selecting a desired signal from received signals. Feed-back type digital filters are widely used to provide less circuit scale and power consumption and sharp frequency characteristic. Reception signal conditions are as follows:

desired signal frequency = modulation factor = 2.5 KHz, channel interval = 12.5 KHz as is assumed above. A pass band $f_c$ is assumed 4 KHz in consideration of a local oscillation frequency deviation. A stop band $f_a$ is assumed 10 KHz by subtracting a modulation factor from an adjacent channel frequency. From the above conditions, the number of filter orders N required for feed back low-pass filter is determined as follows:

$$N = (Aa/12)/\{\log(fa/fc)/\log 2\}$$
$$= 5.7$$

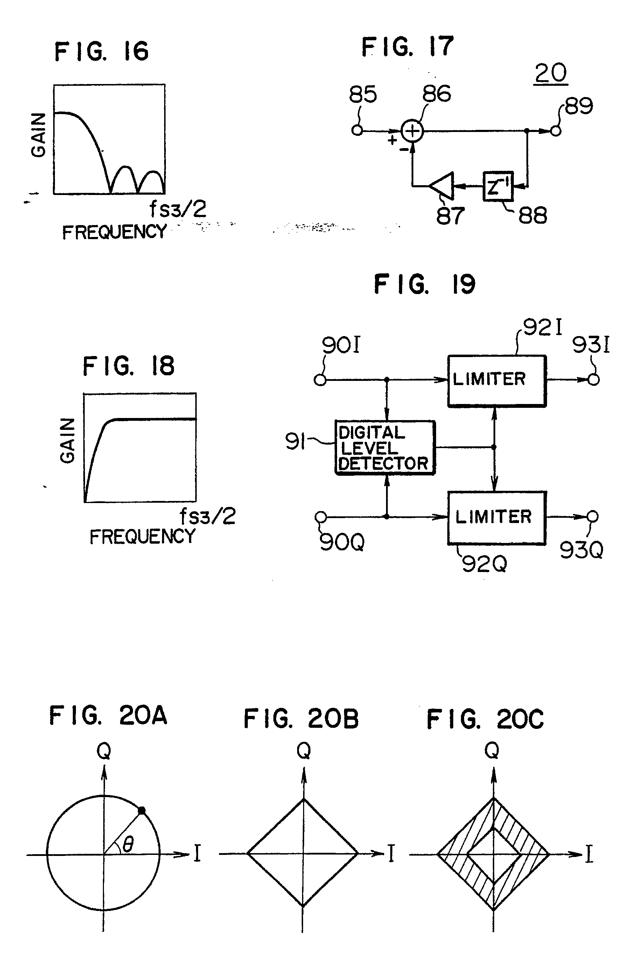

A sixth order filter is required in view of circuit configuration. A configuration of a digital filter is described, for example, in a literature "digital signal processing" written by A.V. Oppenheim and R.W. Schafer: Prentice-Hall: 1975. An example of feed-back sixth order digital filter is shown in Fig. 16. The filter comprises as components, adders 55 through 66, multipliers 73 through 84, and shift registers 67 through 72. A sampling frequency is equal to an output data sampling frequency fs3 (32 KHz) of the A/D converter 10I (10Q). The shift registers 67 to 72 function as delay circuits which provide one sampling period. A filter characteristic such as frequency characteristic is determined by coefficients used in multipliers 73 through 84. Although designation of specific coefficients is omitted, an example of frequency characteristic of the low-pass digital filter shown in Fig. 15 is illustrated in Fig. 16. In order to form the filter on a small scale, there are various filter configurations, for example, selecting a power of 2 as coefficient and using a serial data signal processing in which the multipliers 73 through 84 comprise level shifters. A synthesized characteristic of an IF filter is obtained by synthesizing the frequency characteristic of the decimation filter shown in Fig. 14C with the frequency characteristic of the digital filter shown in Fig. 16. An attenuation band until a half of the sampling frequency fsl of the A/D converter may be obtained by providing the frequency characteristic with a zero point within an aliasing pass band caused in a frequency range not less than a half of the sampling frequency fs3 of the digital filter. Signal components in a frequency range not less than a half of the sampling frequency fs1 (= 512 KHz) for the input data of the A/D converter 10I (10Q) are attenuated by the low pass analog filter 105I (105Q) as mentioned above. Thus, only a desired signal is selected from received signals by a circuit system from the low-pass analog filter 105I (105Q) to the low-pass digital filter 11I (11Q).

A number of differential amplifiers are used in the analog circuit part of the A/D converter 10I (10Q), the low-pass analog filter 105I (105Q) and the previous analog processing part. On forming the differential amplifier, a direct current offset is surely caused. When circuits which are directly (DC) connected with each other with respect to a direct current are used, a DC offset component generated in the above mentioned circuit is superposed upon the received signals. An influence by the DC offset component can be eliminated after demodulation. However, it is effective to eliminate the DC offset component before a limiter 12I (12Q) for extending the dynamic range of input signals to the limiter input signals to the limiter 12I (12Q) and the demodulator 14. A high-pass digital filter 20I (20Q) is provided for removing the DC offset component. An example of the high-pass digital filter 20I (20Q) of Fig. 8 is shown in Fig. 17. Fig. 17 is a diagram showing the simplest high-pass digital filter, which is of a first order feed back type digital filter comprising an adder 86, a shift register 88 and a multiplier 87. The shift register 88 is a delay circuit having sampling frequency fs3 equal to that of the above mentioned low-pass digital filter. Assuming a coefficient of the multiplier 87 be k, a transfer function is as follows:

$$H(Z) = K(1\text{-}Z^{-1})/\{K(1\text{-}Z^{-1}) + Z^{-1}\}$$

A cut-off frequency of the high-pass filter is determined depending upon a value of coefficient k. An example of frequency characteristic of the high pass digital filter 20I (20Q) is shown in Fig. 18. In a specific circuit configuration, the coefficient k may be a power of 2 and the multiplier may comprise a level shifter. In a case that desired signal frequency components after direct conversion in a digital data receiver are concentrated around the modulation frequency of data under the above mentioned conditions, frequency characteristic specifications required for the high-pass digital filter 20I (20Q) are relatively mild. However, in case that the desired signal frequency components are extended to a low frequency range, frequency characteristic specifications required for the high-pass digital filter 20I (20Q) is severe. Alternatively, attenuation of the desired signal due to the high-pass digital filter 20I (20Q) will matter. Accordingly, the high-pass digital filter 20I (20Q) may be omitted in view of the characteristics of subsequent limiter 12I (12Q) and the demodulator 14.

The limiter will now be described. A limiter part has been described with reference to Fig. 8 by dividing it into the level detector 13 and the limiters 12I and 12Q. The digital level detector 105I determines an input signal level by synthesizing signals I and Q applied to input terminals 90I and 90Q, respectively. Specific processing will be described hereafter. The limiters 92I and 92Q apply amplitude-limitation to the inputted signals I and Q by using an output of the digital level detector 91, respectively. If the output signal level is normalized into "1", ideal limiting operation to the input signals Iin and Qin is as follows.

$$\text{Iout} = \text{Iin}/(\text{Iin}^2 + \text{Qin}^2)^{1/2}$$
$$\text{Qout} = \text{Qin}/(\text{Iin}^2 + \text{Qin}^2)^{1/2}$$

The relative relation between the output signals Iout and Qout appearing at input terminals 93I and 93Q exhibits a circle shown in Fig. 20A. In order to accomplish a circuit configuration which satisfies the above formulae, the digital level detector 91 requires two multiplier which calculate a square, an adder and a circuit for determining a root, and the limiters 92I and 92Q require adders. If these circuits are realized, the circuit scale would become large. Hence, there is an approach of approximation by following formulae in order to simplify the circuit configuration.

$$\text{Iout} = \text{Iin}/(|\text{Iin}| + |\text{Qin}|)$$
$$\text{Qout} = \text{Qin}/(|\text{Iin}| + |\text{Qin}|)$$

The relative relation between Iout and Qout in this case exhibits a rhomb (a square which has been rotated by 45°) shown in Fig. 20B. By this approximation, the digital level detector 89 may comprise a circuit for determining two absolute values and an adder. Determination of an absolute value in digital signal processing is accomplished by converting a polarity bit of data into positive and may be correctly realized by compensation depending upon positive and negative data patterns. Accordingly, circuit scale can be reduced in comparison with the circuit configuration for obtaining the characteristics of Fig. 20A. For further simplification, there is another approach that a value $|\text{Iin}| + |\text{Qin}|$ is approximated with an exponent of 2 and is outputted from the digital level detector 91 and subtractors of the limiters 92I and 92Q comprise level shifters. That is, in the digital level detector 91 an exponent of 2 which is most approximate in a position of the most significant bit where data appears from a bit pattern of a result of calculation of a value $|\text{Iin}| + |\text{Qin}|$ and is then outputted. Limiter operation can be carried out by using, for example, shift registers for the limiters 92I and 92Q and applying bit shift to data depending on an exponent of 2 which is the output of the digital level detector 91. In this case, the relative relation between Iout and Qout exhibits a rhomb (a square which has been rotated by 45°) having a hatched width in Fig. 20C because of approximation to an exponent of 2. This can further reduce circuit scale since subtractors are not used for the limiters 92I and 92Q. On the other hand an error is included in an ideal characteristic of the limiter operation due to simplification of circuit.

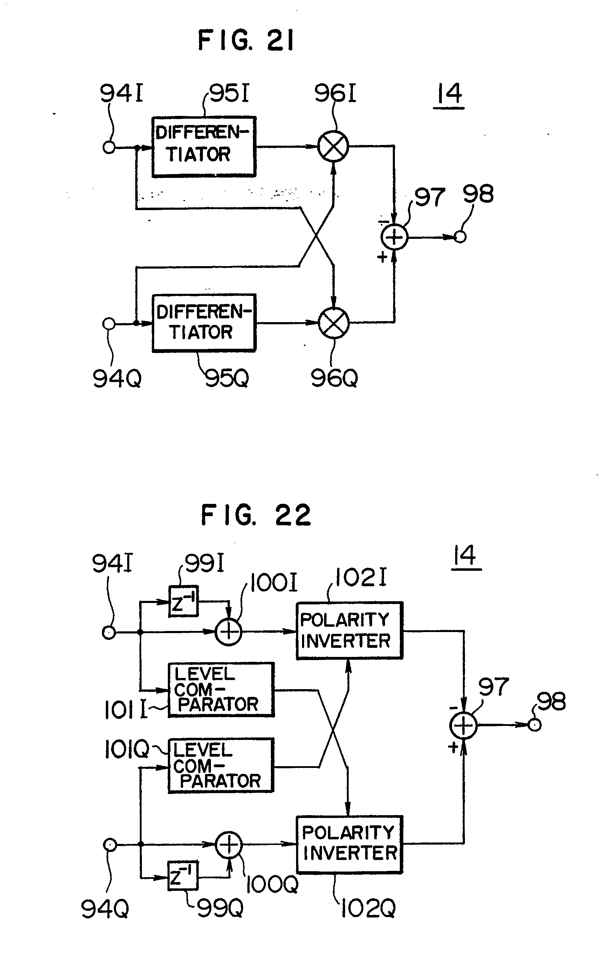

An example of the demodulator will be described with reference to the circuit block diagram of Fig. 21. The output signal of the limiters is applied to input terminals 94I and 94Q in Fig. 21. Ideal limiter output shown in Fig. 20A is exemplarily assumed to be inputted. The received signals is expressed by following formula.

$A \cos \{\omega c + \theta(t)\}$

wherein ωc denotes a carrier angle frequency, θ(t) a modulated signal and A an amplitude.

Since a local oscillation frequency is equal to a carrier frequency in a direct conversion receiver, the received signals on two lines after frequency conversion are expressed as follows:

$Ir(t) = A'\cos \{\theta(t)\}$

$Qr(t) = A'\sin \{\theta(t)\}$

wherein A' denotes an amplitude after frequency conversion.

The received signals after the amplitude limitation by the limiters, that is, input signals I(t), Q(t) to the demodulator are expressed as follows:

$I(t) = \cos \{\theta(t)\}$

$Q(t) = \sin \{\theta(t)\}$

Output signals I'(t), Q'(t) of the differentiators 95I, 95Q are expressed as follows:

$I'(t) = -\sin \{\theta(t)\} \cdot d\theta(t)/dt$

$Q'(t) = \cos \{\theta(t)\} \cdot d\theta(t)/dt$

Output signals Im(t) and Qm(t) of the multipliers 96I, 96Q are expressed as follows:

$Im(t) = -\sin^2 \{\theta(t)\} \cdot d\theta(t)/dt$

$Qm(t) = \cos^2 \{\theta(t)\} \cdot d\theta(t)/dt$

Finally, the output signal Do(t) of the adder 97 is expressed as follows:

$Do(t) = d\theta(t)/dt$

Do(t) shows a rotational direction and a rotational velocity of a phase angle θ in view of relative relation between signals I and Q in Fig. 20A. If the demodulator shown in Fig. 21 is realized by using a digital signal processing circuit, circuit scale would become larger since multipliers are needed. An example of the demodulator in which an approximation calculation is applied for reducing the circuit scale is shown in Fig. 22. A delay circuit 99I (99Q) and an adder 100I (100Q) are combined form a differentiating circuit. Outputs of two differentiating circuits ΔI and ΔQ are expressed as follows:

$\Delta I = I(t) - I(t-1)$

$\Delta Q = Q(t) - Q(t-1)$

wherein t-1 denotes data which is precedent to time by 1 in a digital data train. The upper formula corresponds to differentiation processing of the signals I and Q. An amount which is to be determined as modulated output Do(t) from the relative relation between signals I and Q in Figs. 20A through 20C corresponds to a change Δθ in θ in Figs. 20A through 20C. A distance p between P(t) -P(t-1) is determined as an approximated value having Δθ. ΔP can be approximated by following formula.

$|\Delta P| = \sqrt{\Delta I^2 + \Delta Q^2} \fallingdotseq |\Delta I| + |\Delta Q|$

Rotational direction of θ may be determined according to combinations in following Table at each quadrant of Figs. 20A to 20C. Therefore, a value ΔP and its polarity can be determined by determining on which quadrant of Fig. 14 P(t) exists.

| Quadrant | 1 | | 2 | | 3 | | 4 | |
|---|---|---|---|---|---|---|---|---|
| It | P | | N | | N | | P | |
| Qt | P | | P | | N | | N | |
| Rotational direction θ | P | N | P | N | P | N | P | N |
| Value ΔI | N | P | N | P | P | N | P | N |
| Value ΔQ | P | N | N | P | N | P | P | N |
| N: Negative, P: Positive | | | | | | | | |

18

The above Table is summarized as follows:

| It | Qt | ΔP |
|----|----|----|
| P | P | $-\Delta I + \Delta Q$ |
| N | P | $-\Delta I - \Delta Q$ |
| N | N | $\Delta I - \Delta Q$ |
| P | N | $\Delta I + \Delta Q$ |
| N: Negative, P: Positive | | |

The demodulator may be formed without multipliers by conducting processing according to the above Table. A level comparator 101I (101Q) determines a polarity of It and Qt in Fig. 22. In order to calculate ΔP in the above Table by the adder 97, a polarity inverter 102I (102Q) converts the polarity of the outputs ΔI and ΔQ of two differentiating circuit according to an output of the level comparator 101I (101Q). An output corresponding to the above mentioned AP may be provided at an output terminal 98 by the operation as mentioned above.

An example of a low-pass digital filter 103 will now be described. The basic structure of the filter is identical with that of the above mentioned low-pass digital filter 11I (11Q). The number of filter stages and coefficients are determined depending on required frequency characteristic.

Exemplary structures and operations of the receiver of the present invention have been described. There are various structures other than those described with respect to specific circuit of each part of the direct conversion receiver as shown in Fig. 18.

Now, gain control of an RF band variable gain amplifier 2 of the present invention will be described. The RF band variable gain amplifier 2 has a different plural gains and is capable of selecting any one of the gains responsive to an external signal. The level comparator 4 in advance stores reference data and compares the reference data with the digital data outputted from the digital level detector 13 for providing the gain controller 3 with data necessary for switching the gain of the RF band variable gain amplifier 2 depending upon a comparison result. The gain controller 3 receives the data from the level comparator 4 for switching the gain of the RF band variable gain amplifier 2. Since the output of the digital level detector 13 corresponds to the desired signal level, the above-mentioned system makes it possible to control the gain of the receiver depending on the desired signal level.

The above-mentioned RF band variable gain amplifier 2 may comprise, for example, high and low gain amplifiers and these amplifiers may be selectively switched. The RF band variable gain amplifier 2 uses the high gain amplifier when the level of the desired signal detected by the digital level detector 13 is lower than the preset reference level. The RF amplifier 2 uses the low gain amplifier when the level of the desired signal detected by the digital level detector 13 is higher than the reference level. Input-to-output characteristic from an input terminal of the RF band variable gain amplifier 2 to an output terminal of an IF band variable gain amplifier 7I (7Q) in relation to received mixed signals on a plurality of channels will be described with reference to two cases. A first case is that only an input level of the undesired signal is changed while the input level of desired level is kept constant. A second case is that only an input level of the desired signal is changed while the input level of the undesired signal is kept constant. The relation between the input level of the RF band variable gain amplifier 2 and the output level of the IF band variable gain amplifier 7I (7Q) is shown in Figs. 23A and 23B.

Since the level of the desired signal is constant in the above-mentioned first case, the desired signal is eliminated by the digital filter 11I (11Q) and the output signal of the digital filter 11I (11Q) is only desired signal, resulting in a constant output level if the desired signal level is lower than a gain controllable level of the IF band variable gain amplifier 7I (7Q). For simplicity of description, influence of the fact that attenuation outside of the band of the digital filter is finite and influence of inter-modulation is omitted herein. The output level of the digital level detector 13 is constant due to a fact that the output level of the digital filter 11I (11Q) is constant as mentioned above. The result of comparison and determination by the level comparator 104 is also constant and the gain of the RF band variable gain amplifier 2 is fixed at any one of high or low gain. When the desired signal level is so low that the gain of the RF band variable gain amplifier 2 is preset to a high value, an increase in the undesired signal level causes the input-to-output signal

19

characteristic to assume a curve denoted as "high gain" in Fig. 23A, which is linear until input level reaches at point A'. When the undesired signal input level exceeds point A', gain control of the IF band variable gain amplifier 7I (7Q) commences so that the output level in relation to the input level not less than point A' is constant at point B. On the other hand, when the desired signal level is high and the RF band variable gain amplifier 2 is preset at a high gain, input-to-output characteristic in relation to the undesired signal level assumes an input-to-output characteristic curve represented as "low gain" in the drawing. In this case, the curve is linear until the input level reaches at point A. When the input level exceeds point A, gain control of the IF band variable gain amplifier 7I (7Q) commences so that the output level in relation to the input level not less than point A is constant at point B. When the received signal level exceeds point A in Fig. 23A gain of the IF band variable gain amplifier 7I (7Q) is controlled so that an output level becomes constant. An influence of gain control in the IF band variable gain amplifier 7I (7Q) will be considered herein. Gain control in the IF band variable gain amplifier 7I (7Q) has a characteristic that the gain will be lowered with increase in the input signal level for keeping the output level constant. Accordingly, if received signal is such that the undesired signal level is higher than the desired signal level and the desired signal level is constant, increase in the level of the received signal causes the desired signal level in the output signal of the IF band variable gain amplifier 7I (7Q) to be substantially lowered. This also causes the output level of the digital filter 11I (11Q) and the digital level detector 13 to be lowered. If the level comparator 4 determines that the desired signal level is less than a reference level when the received signal level is less than point A, the determination result of the level comparator 4 would not change although the undesired signal level increases to lower the gain of the IF band variable gain amplifier 7I (7Q), resulting in lowering of the desired signal level. Accordingly, the gain of the RF band variable gain amplifier 2 will not change and assumes respective input-to-output characteristic curves shown in Fig. 23A. If the desired signal level is high and the level comparator 4 determines that the desired signal level is higher than a reference level, the determination result of the level comparator 4 will change when the desired signal level is lower than the reference level with lowering in the gain of the IF band variable gain amplifier 7I (7Q). Hence, it is to be noted that it is necessary to preset a reference level in the level comparator 4 and the gain of the RF band variable gain amplifier 2 by considering a maximum input level of received signal so that the gain of the RF band variable gain amplifier 2 is not switched by a factor other than the desired signal level in the automatic gain control in the present invention.

Input-to-output characteristic in the second case will be described. An input-to-output characteristic in relation to desired signal is shown in Fig. 23B. When the undesired signal level is lower than the desired signal level, the gain of the RF band variable gain amplifier 2 is controlled depending upon the desired signal level since the undesired signal level is kept constant. The level comparator 4 generates an output signal to the gain controller 3 to preset the gain of the RF band variable gain amplifier 2 high when the desired signal level is so low that the level comparator 4 determines that the desired signal level is lower than a reference level. The level comparator 4 changes an output signal for the gain controller 3 to lower the gain of the RF band variable gain amplifier 2 when the desired signal level increases to exceed the reference level. The output level of the digital filter 11I (11Q) is also constant since the output level of the IF band variable gain amplifier 7I (7Q) is constant with respect to the desired signal level which exceeds point A in the input-to-output characteristic curve in Fig. 23B. Accordingly, it is necessary to preset the reference level in the level comparator 4 to a value corresponding to the desired signal level lower than point A as shown in Fig. 23B. The output level of the digital level detector 13 corresponding to, for example, point C of the desired signal input level is preset as a reference level of the level comparator 4. When the desired signal level is not higher than point C1, the level comparator 4 determines that the desired signal level is not higher than the reference level and the RF band variable gain amplifier 2 is preset to a high gain. When the desired signal level exceeds point C, the level comparator 4 changes the output signal for the gain controller to lower the gain of the RF band variable gain amplifier 2. The gain controller 3 receives a signal from the level comparator 4 to switch the gain of the RF band variable gain amplifier 2. When the desired signal level increases to reach point A, the gain of the IF band variable gain amplifier 7I (7Q) is controlled so that the output level is fixed to point B. Since the output level will lower from point D to point E when the gain of the RF band variable gain amplifier 2 is switched to a low gain at point C, the level of outputs from the digital filter 11I (11Q) and the digital level detector 13 will also lower. As a result of this, the desired signal level in the level comparator 4 becomes not higher than the reference level. If the level comparator 4 is enabled at this time, the level comparator 4 generates a signal to the gain controller 3 to switch the gain of the RF band variable gain amplifier 2 to a high value so that gain control of the RF band variable gain amplifier 2 becomes unstable. Accordingly, the reference level of the level comparator 4 is changed to a value corresponding to point E of the output level in Fig. 2B after the desired signal level exceeds point C and the RF band variable gain amplifier 2 is switched to a low gain. The above mentioned operation makes it possible to control gain depending on the desired signal level.

An improvement in dynamic range of the desired input signal level by a value corresponding to a switching amount of the gain of the RF band variable gain amplifier 2 can be accomplished in accordance with the present invention. Since the gain of the RF band variable gain amplifier 2 is lowered in accordance with the present invention when the desired signal level exceeds a preset reference level, this will not give any influence upon a demodulation system on input of a low level signal. Inter-modulation characteristic can be improved since the gain of the RF band variable gain amplifier 2 is lowered when an over level signal is inputted. That is, intermodulated signals generated in the mixer 5I (5Q) and IF variable gain amplifier 7I (7Q) are lowered by lowering the output level of the RF band variable gain amplifier 2. Further, circuit configuration may be changed for improving inter-modulation characteristic of the RF band variable gain amplifier 2 when the gain is low.

The received signal level varies with time in a normal receiving state due to fading effect and the like. When the desired signal level varies below and above an input signal level corresponding to point C in Fig. 23B, the gain of the RF band variable gain amplifier 2 should be frequently switched. As a result of this switching, the output level of the digital filter 11I (11Q) frequently changes and transient phenomenon by gain switching is further added so that these will give an adverse influence upon a subsequent demodulation system. An embodiment for avoiding this will be described with reference to an input-to-output characteristic curve in Fig. 24. Points A, B, C, D, and E in the graph of Fig. 24 are identical with corresponding point shown in Fig. 23B. Operation to the RF band variable gain amplifier 2 when the desired signal input level reaches point C is identical with that of the above mentioned embodiment. Presetting of the reference level in the level comparator 4 when the gain is low is changed from point E in the first embodiment to point H. If the desired signal input level is lowered after the RF band variable gain amplifier 2 has been rendered a low gain, the gain of the RF band variable gain amplifier 2 would be fixed until the input level reaches point F. When the input level becomes lower than point F, the level comparator 4 provides the gain controller 3 with a gain switching signal to change the gain of the RF band variable gain amplifier 2 to a high gain. This provides a marginal range between points C and F in Figs 2B so that instability in gain control caused by change in level due to fading effect and the like may be avoided.

In the above mentioned embodiments, the RF band variable gain amplifier 2 is formed in such a manner that any one of two gains of the amplifier is selected. There is also an approach that the RF band variable gain amplifier 2 is provided with a plurality of gains and any one of the gain is selected. The RF band variable gain amplifier 2 is provided with more than 2 gains and the gain controller 3 is converted in such a manner that it can control gains having the numbers equal to those of the RF band variable gain amplifier. A plurality of reference levels are preset to the level comparator 4 to conform to a desired input-to-output characteristic. This can realize more complicated gain control in comparison with the input-to-output characteristic of Fig. 24. A dynamic range relative to a desired signal level could be extended and inter-modulation characteristic could be further improved in comparison with the above mentioned embodiments.

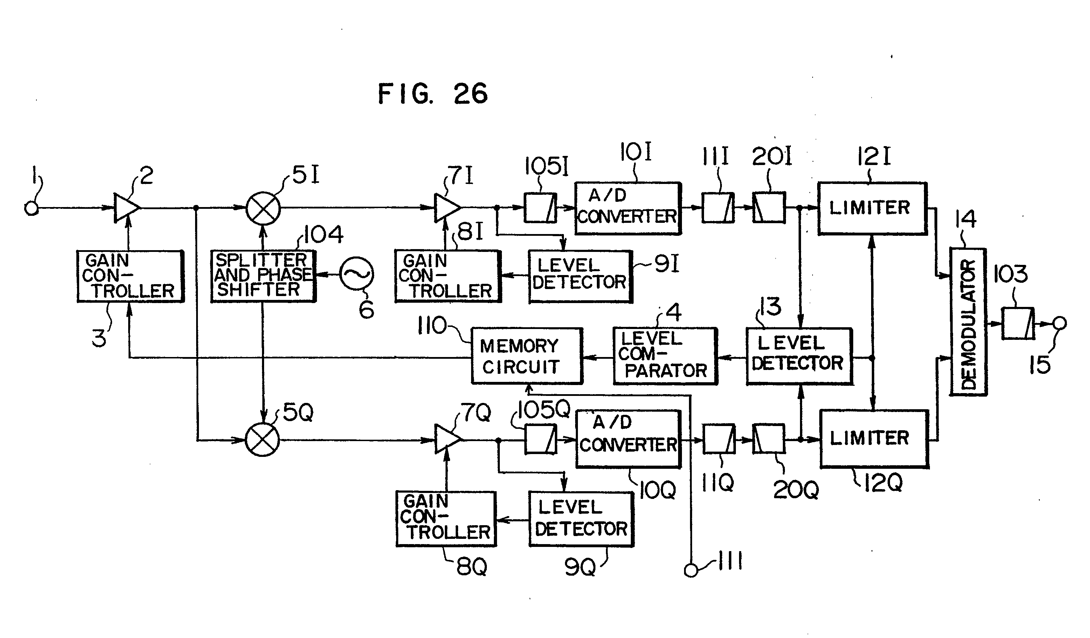

Now, another embodiment of the present invention will be described with reference to Fig. 26. In the embodiment shown in Fig. 8, a reference level preset in a level comparator 4 is fixed. Fixed data is more effective from view point of circuit scale. It is also effective that the input-to-output characteristic can be changed responsive to an external signal according to purposes if versatility of level comparison and gain control attendent thereon is considered. Fig. 26 is a block diagram showing a receiver which is added with a memory circuit 110 which is writable by an external signal via a control signal input terminal 111. A reference level used in the level comparator 4 is stored in the memory circuit 110. The memory circuit 110 is writable so that memory information may be written via a control signal input terminal 111. It is desirable that the memory circuit 110 can hold memory information even if power to other circuits is turned off. The level comparator 4 generates gain control information to the gain controller 3 by using reference levels stored in the memory circuit 110 and the output from the level detector 4. As a result of this, gain control may be changed according to circumstances. A part of the memory circuit 110 comprises a read-only-memory in which basic information is stored. Gain control may be carried out by using, as reference levels, the basic information stored in the read-only memory unless information is inputted to the writable memory by an external signal.

An intermittent receiving performed by the above mentioned receiver as an application of the above embodiment will now be described (not shown). An intermittent receiving is a receiving mode in which receiving and pause states are alternatively repeated at a preset period of time. Depending on the system and the terminals various schemes are available as the state of the receiver in a pause state. As a typical example, the receiving part except for the control part is turned off. Accordingly, the gain of the above mentioned RF band variable gain amplifier will be returned to an initial level once the receiver is brought into a pause state unless a special function is added. The desired signal level scarcely abruptly changes on intermittent receiving for a relatively short period of time. Therefore, when the receiver is brought into a pause state from a receiving state and then brought into a pause state, there is a strong likelihood that the desired signal level is approximate to that in the previous receiving state. Accordingly, gain control can be quickly commenced when the receiver is brought into next receiving state by storing information on gain control in the previous receiving state until next receiving state. The difference between the present embodiment and the embodiment described with reference to Fig. 26 resides in a memory circuit 110. The memory circuit 110 comprises a writable memory circuit which can hold stored information even if a power source for radio receiver is turned off in Fig. 26. The memory circuit 110 receives and transmits information from and to the level comparator 4. Information outputted from the level comparator 4 is stored in the memory circuit 110. The gain controller 3 changes the gain of the RF band variable gain amplifier 2 depending on the information stored in the memory circuit 110. When the receiver is brought into a pause state, a power source for circuit other than the memory circuit 110 is turned off. At this time, information on gain control stored in the memory circuit 110 is held. When the receiver is brought into a receiving state, the gain controller 3 changes the gain of the RF band variable gain amplifier 2 to the gain in previous receiving state by using gain control information stored in the memory circuit 110, on the other hand, the level comparator 4 determines which gain the RF band variable gain amplifier 2 assumes with reference to gain control information stored in the memory circuit 110 and selects a reference level used for level comparison.

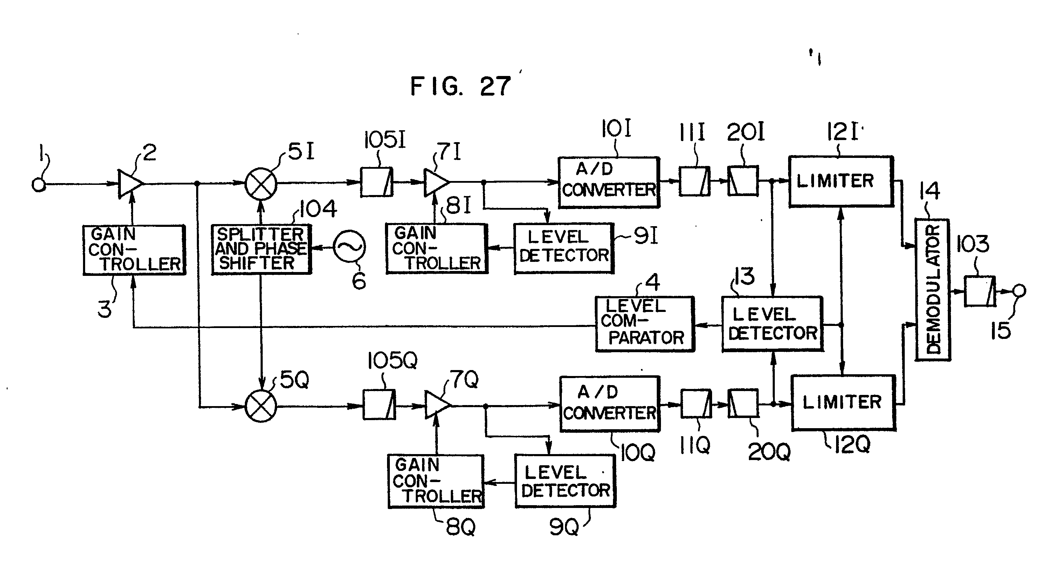

An embodiment in which suppression of the desired signal caused by lowering in the gain of the IF band variable gain amplifier due to an undesired or interfering signal is improved with reference to Fig. 27. A difference in the configuration of the direct conversion receiver between the present invention of Fig. 27 and that of Fig. 8 resides in arrangement of IF amplifier 7I (7Q), 8I (8Q), 9I (9Q) and low pass analog filters 105I (105Q). A direct detector of Fig. 8 will be compared with that of Fig. 27. Since frequency band limitation is conducted by a low pass analog filter before IF amplification in the latter, undesired signal having a high frequency components included in input signals of the IF amplifier is reduced by narrowing the pass band of the low-pass analog filter 105I (105Q) than a value determined by a sampling frequency of the A/D converter 10I (10Q) and the like, resulting in an improvement in an over-input characteristic. An arrangement of inherently necessary filters is simply changed. Circuit scale and power consumption will not be increased unless filter characteristic is substantially changed. However, since an IF amplifier is disposed at a subsequent stage of a low-pass filter so that high frequency noise components generated in the IF amplifier are inputted to an A/D converter without being processed, a problem may be caused conversely. Accordingly, formation of a receiver suitable for capabilities of an IF amplifier, a low-pass analog filter, and an A/D converter is accomplished.

In accordance with the above mentioned embodiments, a radio receiver having a high sensitivity may be realized by low power and small scale circuits.

Detail effects of the present embodiments are as follows:

firstly, a demodulation system may be readily changed and versatility of receiver may be enhanced by making a digital signal processing part programmable since an analog signal processing circuit is applied for a high frequency part and a digital processing circuit is applied after frequency conversion.

Secondary, the gain of an RF amplifier is changed depending on the signal level of a desired signal. Since the signal level of the desired signal is processed in a digital signal processing part, gain control may be realized without addition of a capability of selecting a desired signal. Gain control may be realized depending on the desired signal level by an additional smaller circuit as shown in the embodiments. This can extend a dynamic range relative to a desired signal input level. In particular, an inter-modulated signal generated on an over-input of received signals on a plurality of channels can be reduced by gain control of an RF amplifier.

Thirdly, since the reference levels in the level comparator can be preset in response to an external signal, freedom of input-to-output characteristic in relation to a desired signal would become high. A high versatility could be provided if a circuit for realizing frequency selective gain control is incorporated in a receiver or is formed of ICs. If gain control information in previous receiving state in an intermittent receiver is stored and is used when the receiver is brought into next receiving state from a pause state, a rise-up time of gain control when the receiver is brought into a receiving state could be shortened.

By reversing an arrangement of the IF band variable gain amplifier and the low-pass analog filter, the undesired signal level is suppressed before the IF band variable gain amplifier for mitigating the lowering in the gain of the IF band variable gain amplifier due to undesired signal so that suppression of the desired signal can be reduced.

**Claims**

1. A radio receiver comprising for outputting a signal which has been demodulated from a radio frequency band signal received by an antenna, comprising:

a radio frequency variable gain amplifier (2) for amplifying a radio frequency band signal which is received by an antenna;

converting means (5) for converting the output from said radio frequency variable gain amplifier (2) into an intermediate frequency band signal;

a demodulator (14) for demodulating said intermediate frequency signal; and

a gain controller (3) for controlling the gain of said radio frequency variable gain amplifier depending upon a result of comparison of the level of said intermediate frequency band signal with at least one of predetermined reference levels.

2. A radio receiver according to Claim 1, wherein said radio frequency variable gain amplifier (2) comprises at least two amplifiers having gains different with each other and selecting means for selecting any one of said amplifiers under control of said gain controller (3).

3. A radio receiver according to Claim 1, wherein said gain controller (3) uses a predetermined first reference level as said reference level which is compared with the level of said intermediate frequency band signal when said gain controller controls to change the gain of said radio frequency variable gain amplifier (2) from a low gain to a high gain and uses a second reference level lower than said first reference level as said reference level which is compared with the level of said intermediate frequency band signal when said gain controller controls to change the gain of said radio frequency band variable gain amplifier from a high gain to a low gain.

4. A radio receiver according to Claim 2, wherein said gain controller (3) uses a predetermined first reference level as said reference level which is compared with the level of said intermediate frequency band signal when said gain controller controls switching to said second amplifier having a gain lower than that of said first amplifier from said first amplifier included in said radio frequency variable gain amplifier and uses a second reference level lower than said first reference level as said reference level which is compared with the level of said intermediate frequency band signal when said gain controller controls switching to said second amplifier from the first amplifier.

5. A radio receiver according to Claim 1, wherein said radio frequency variable gain amplifier (2) comprises first, second and third amplifiers having gains different from each other; and selecting means for selecting any one of said amplifiers under control of said gain controller (3).

6. A radio receiver according to Claim 5, wherein said gain controller (3) uses a predetermined first reference level as said reference level which is compared with the signal level of said intermediate frequency band signal when said gain controller controls switching from said first amplifier included in said radio frequency variable gain amplifier (2) to said second amplifier having a gain lower than that of said first amplifier or when said gain controller controls switching from said second amplifier included in said radio frequency variable gain amplifier to said third amplifier having a gain lower than that of said second amplifier,

and uses a predetermined second reference level lower than the first reference as said reference level which is compared with the signal level of said intermediate frequency band signal when said gain controller controls switching from said second amplifier to said first amplifier or when said gain controller controls switching from said third amplifier to said second amplifier.

7. A radio receiver according to Claim 5, wherein said gain controller (3) uses a predetermined first reference level as said reference level which is compared with the signal level of said intermediate frequency band signal when said gain controller (3) controls switching from said first amplifier included in said radio frequency variable gain amplifier to said second amplifier having a gain lower than that of said first amplifier, and uses a predetermined second reference level lower than the first reference as said reference level which is compared with the signal level of said intermediate frequency band signal when said gain controller (3) controls switching from said second amplifier to said third amplifier having a gain lower than that of said second amplifier, and

uses a predetermined third reference level lower than the first reference as said reference level which is compared with the signal level of said intermediate frequency band signal when said gain controller (3) controls switching from said second amplifier to said first amplifier, and

uses a predetermined fourth reference level lower than the second reference as said reference level which is compared with the signal level of said intermediate frequency band signal when said gain controller (3) controls switching from said third amplifier to said second amplifier.

8. A radio receiver according to Claim 1 and further including means (18) for inputting data, and a memory (17) for storing said inputted data, and wherein said gain controller uses said data stored in said memory as said reference level which is compared with the signal level of said intermediate frequency band signal.

9. A radio receiver according to Claim 8, wherein said memory comprises a first memory area writable by said data inputting means and a second memory area for preliminarily storing predetermined data, and wherein said gain controller uses the data which has been written in said first memory area as said reference level which is compared with the signal level of said intermediate frequency band signal when the data has been written in said first memory area and uses the data which has been written in said second memory area as said reference data when no data has been written in said first memory area.

10. A radio receiver according to Claim 1, wherein said gain controller (3) comprises a level comparing circuit (4) for comparing the signal level of said intermediate frequency band signal with said reference level, a memory for storing for a predetermined period of time a result of comparison outputted from said level comparing circuit and a gain control circuit for controlling the gain of said radio frequency variable gain amplifier in response to the comparison result stored in said memory.

11. A radio receiver for obtaining a demodulated data signal by using a direct conversion system for demodulating a radio frequency band signal with angle modulation which has been received by an antenna, comprising;

a radio frequency variable gain amplifier (2) for amplifying said radio frequency band signal;

a converter (5) which generates two reference signals having a given phase difference from a frequency fallen in said radio frequency band for converting said radio frequency band signal amplified by said radio frequency variable gain amplifier into two intermediate frequency band signals by using said respective reference signals and for processing the respective converted signals;

a demodulator for demodulating the signals which are outputted from said converter; and

a gain controller (3) for controlling the gain of said radio frequency variable gain amplifier in response to a result of comparison of the signal levels of the signals outputted from said converter with at least one of said predetermined reference levels.

12. A radio receiver according to Claim 11, wherein said gain controller (3) uses a first reference level as said reference level which is compared with the level of said intermediate frequency band signal when said gain controller (3) controls the gain of said radio frequency variable gain amplifier (2) from a low gain to a high gain and uses a second reference level as said reference level which is compared with the level of said intermediate frequency band signal when said gain controller controlls the gain of said radio frequency variable gain amplifier from a high gain to a low gain.

13. A radio receiver according to Claim 11, wherein said radio frequency variable gain amplifier (2) comprises at least two amplifiers having gains different with each other and selecting means for selecting any one of said amplifiers under control of said gain controller.

14. A radio receiver according to Claim 13, wherein said gain controller includes;

a level comparator (4) for comparing the signal level of the signals outputted for said converter with at least one of predetermined reference levels; and

a gain controlling circuit (3) for controlling the selection of amplifiers of said radio frequency variable gain amplifier.

15. A radio receiver according to Claim 13, wherein said gain controller (3) uses a predetermined first reference level as said reference level which is compared with the level of said intermediate frequency band signal when said gain controller (3) controls switching from the first amplifier included in said radio frequency variable gain amplifier to a second amplifier having a gain lower than that of a first amplifier and uses a second reference level lower than said first reference level as said reference level which is compared with the level of said intermediate frequency band signal when said gain controller controls switching from the second amplifier to the first amplifier.

16. A radio receiver according to Claim 11 further including means (18) for inputting data, and a memory (17) for storing said inputted data, and wherein said gain controller using said data stored in said memory as said reference level which is compared with the signal level of said signals outputted from said converter.

17. A radio receiver according to Claim 16, wherein said memory (17) comprises a first memory area writable by said data inputting means and a second memory area for preliminarily storing predetermined data, and wherein said gain controller uses the data which has been written in said first memory area as said reference level which is compared with the signal level of said intermediate frequency band signal when the data has been written in said first memory area and uses the data which has been written in said second memory area as said reference data when no data has been written in said first memory area.

18. A radio receiver according to Claim 11, wherein said gain controller (3) comprises a level comparing circuit (4) for comparing the level of said intermediate frequency band signal with said reference level, a memory for storing for predetermined period of time the result of comparison outputted from said level comparing circuit and a gain control circuit for controlling the gain of said radio frequency variable gain amplifier in response to the comparison result stored in said memory.

19. A radio receiver according to Claim 11, wherein said converter includes;

a mixer (5) for converting said radio frequency band signal amplified by said radio frequency variable gain amplifier into two intermediate frequency signals by using said respective reference signals;

an intermediate frequency variable gain amplifier (7) for amplifying said intermediate frequency band signals;

a low-pass analog filter (105I, 105Q) for respectively limiting the band of the frequency through which said amplified intermediate frequency band signals may pass into a predetermined frequency band;

an analog-to-digital converter (10I, 10Q) for converting the signal outputted from said low-pass filter (105I, 105Q) into digital signals; and

a digital filter (11I, 11Q) for limiting the band of frequency through which said digital signals may pass into a predetermined band of frequency.

20. A radio receiver according to Claim 11, wherein said converter includes;

a mixer (5) for converting said radio frequency band signal amplified by said radio frequency variable gain amplifier (2) into two intermediate frequency signals by using said respective reference signals;

an intermediate frequency variable gain amplifier (7) for amplifying said intermediate frequency band signals;

a low-pass analog filter (105I, 105Q) for respectively limiting the frequency of said amplified intermediate frequency band signals into predetermined frequency band;

an analog-to-digital converter (10I, 10Q) for converting the signals outputted from said low-pass filter into digital signals; and

a digital filter (11I, 11Q) for limiting a band of frequency through which said digital signals may pass into a predetermined band of frequency.

# FIG. 1

EP 0 413 311 A2

# FIG. 2A

# FIG. 2B

# FIG. 3

27

# FIG. 4

# FIG. 5

# F I G. 6

EP 0 413 311 A2

## FIG. 7

EP 0 413 311 A2

FIG. 8

FIG. 9

104

26  R  27a

C

C  27b

R

FIG. 10A

AMPLITUDE

0 dB

3 dB

120b

120a

fo

FREQUENCY

FIG. 10B

PHASE

+45°

-45°

120b

90°

120a

fo

FREQUENCY

FIG. 11

105

28

C1

C3

31

R1  R2  29  R3  R4  30

C2  C4

# FIG. 12

10

# FIG. 13

# FIG. 14A

EP 0 413 311 A2

FIG. 14B

GAIN

fs3
FREQUENCY

FIG. 14C

GAIN

fs3 fs2 ... fsı/2
FREQUENCY

FIG. 15

# FIG. 16

GAIN

fs3/2

FREQUENCY

# FIG. 17

20

85  86  89

+
−

87  88
Z⁻¹

# FIG. 18

GAIN

fs3/2

FREQUENCY

# FIG. 19

90I  92I  93I

LIMITER

91  DIGITAL
LEVEL
DETECTOR

90Q  92Q  93Q

LIMITER

# FIG. 20A

Q

θ

I

# FIG. 20B

Q

I

# FIG. 20C

Q

I

# FIG. 21

# FIG. 22

# F I G. 23A

OUTPUT SIGNAL LEVEL

B

A'  A

INPUT SIGNAL LEVEL

# F I G. 23B

OUTPUT SIGNAL LEVEL

B
D

E

C  A

INPUT SIGNAL LEVEL

# F I G. 24

OUTPUT SIGNAL LEVEL

B
D
G
E
H

F  C  A

INPUT SIGNAL LEVEL

# F I G. 25

2

113  114  SWITCH  115  117  SWITCH  118

116  119

FIG. 26

FIG. 27

# FIG. 28
PRIOR ART

# FIG. 29   PRIOR ART

EP 0 413 311 A2

# FIG. 30 PRIOR ART